# EUROPEAN PATENT APPLICATION

(11) **EP 2 224 499 A1**
(43) Date of publication of application: **01.09.2010**
(21) Application number: 08863219.5
(22) Date of filing: 30.09.2008
(51) Int. Cl.: H01L 31/20, B65G 49/06, B65D 85/86

(54) **THIN-FILM SOLAR CELL MANUFACTURING SYSTEM AND COMMON SUBSTRATE STORAGE RACK**

(30) Priority: 18.12.2007 JP 2007325777
(71) Applicant: Mitsubishi Heavy Industries, Ltd., Tokyo 108-8215 (JP)
(72) Inventor: AKIYAMA, Masaki, Nagasaki-shi Nagasaki 850-8610 (JP); INOUE, Masashi, Nagasaki-shi Nagasaki 850-8610 (JP)
(74) Representative: Bongiovanni, Simone
(86) International application number: PCT/JP2008/067763
(87) International publication number: WO 2009/078209

(57) **Abstract**

A thin-film solar-cell manufacturing system enabling a reduction in installation space in a factory.

The thin-film solar-cell manufacturing system includes a first common substrate storage rack (40-1), a second common substrate storage rack (40-2), and a plurality of processing equipments (1 to 16-2). The first common substrate storage rack (40-1) and the second common substrate storage rack (40-2) accommodate the substrate being tilted. The plurality of processing equipments (1 to 16-2) are used to process the substrate in manufacturing steps of the thin film solar-cell and are disposed in a region between the first common substrate storage rack (40-1) and the second common substrate storage rack (40-2), the plurality of processing equipments being disposed such that one of substrate loaders and substrate unloaders face the first common substrate storage rack (40-1) and the other face the second common substrate storage rack (40-2). The first common substrate storage rack (40-1) and the second common substrate storage rack (40-2) are shared by the plurality of processing equipments (1 to 16-2).

## Description

### Technical Field

The present invention relates to a thin-film solar-cell manufacturing system and a common substrate storage rack.

### Background Art

A known solar cell is a thin-film solar cell. A thin-film solar cell is manufactured mainly by a modular-forming step and a paneling step. In the modular-forming step, a module is formed by integrating cells by depositing a transparent electrode layer, a photoelectric conversion layer, and a back electrode layer on a glass substrate and by performing laser etching on each layer. In the paneling step, a panel is formed by covering the modules with an adhesive sheet (EVA) and a back sheet and providing a terminal box. In this way, a thin-film solar cell is manufactured through complicated processing steps using many processing equipments.

As a system for manufacturing a thin-film solar cell, a thin-film solar-cell manufacturing system is disclosed in Japanese Unexamined Patent Application, Publication No. 2005-235904. Fig. 1 is a structural diagram illustrating an embodiment of this thin-film solar-cell manufacturing system. The arrangement of equipments of the thin-film solar-cell manufacturing system used in the steps of the amorphous silicon solar cell manufacturing will be described by following the flow of the substrate. First, in the modular-forming step, a glass substrate received by a substrate loading device 101 in a normal atmosphere 131 is processed at a substrate cleaner 102, a control device 103, a transparent-electrode-film depositing device 104, and a substrate cleaner 105. Then, the glass substrate is conveyed into a clean room 130 by a substrate conveyer 106. Subsequently, the glass substrate is processed at a laser etching device 107, a substrate cleaner 108, a substrate conveyer 109, an amorphous-silicon-film depositing device (plasma CVD device) 110, a substrate conveyer 111, a laser etching device 112, a back-electrode depositing device 113, a substrate conveyer 114, a substrate cleaner 115, a back surface laser etching device 116, a substrate conveyer 117, a power-generation inspection device 118, and a substrate buffer device 148. The module is completed as described above. Next, in the paneling step, after the module is conveyed to a normal atmosphere 132 by a substrate conveyer 119, it is processed at a film polisher 120, a substrate cleaner 121, a lay-up device 122, a laminator 123, a paneling device 124, a terminal-base attaching device 125, a substrate conveyer 126, and a power-generation inspection device 127. Then, the module is sorted into a performance-sorted storage container 128. The panel is completed as described above.

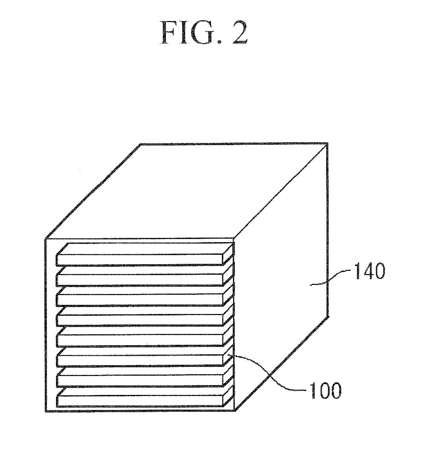

In this way, the processing equipments are arranged in an S-shaped snake-like line and are sequentially connected by substrate conveyers. In this thin-film solar-cell manufacturing system, a substrate cassette 140 in which a substrate is temporarily stored is provided for almost each processing equipment (each manufacturing step) as a buffer for substrate accumulation that occurs due to the processing takt time difference or maintenance cycle of each processing equipment. Fig. 2 is a structural diagram illustrating a substrate cassette. Substrates 100 are horizontally stored in the substrate cassette 140 in such a manner that the substrates 100 are stored laterally and horizontally. The substrate cassette 140 can be conveyed using a ceiling crane (not shown).

As related art, Japanese Unexamined Patent Application, Publication No. HEI-8-139153 discloses a single wafer processing equipment, a substrate conveying device, and a cassette. The single wafer processing equipment 1 is a device for unloading a substrate stored in the cassette in an oblique orientation and loading the substrate into the cassette after performing various types of substrate processing on each substrate. The single wafer processing equipment 1 includes a cassette mounting base on which the cassette is mounted; a first substrate delivery unit for delivering the substrate; an indexer robot for conveying each substrate while the substrate is held at a vertical orientation between the cassette mounted on the cassette mounting base and the first substrate delivery unit; a plurality of processing units for processing the substrate in an oblique orientation; and a substrate conveying robot for conveying the substrate while the substrate is held at an oblique orientation between the first substrate delivery unit and each processing unit. Furthermore, the Publication includes a description of decreasing the conveying space by decreasing the area occupied by the cassette accommodating the substrates obliquely and conveying the substrates obliquely.

Japanese Unexamined Patent Application, Publication No. HEI-10-123193 discloses an inspection device and inspection method for a display panel substrate. The inspection device inspects the display panel substrate by contacting a probe to an electrode on the display panel substrate placed on a worktable. The inspection apparatus includes a cassette, the worktable, a substrate conveying mechanism, and a probe unit. The cassette accommodates a plurality of display panel substrates at an oblique angle of 65° to 80° with respect to a horizontal plane. The mounting surface on the worktable on which the display panel substrate is placed is disposed at the above-mentioned oblique angle with respect to a horizontal plane. The substrate conveying mechanism can unload each display panel substrate in an oblique orientation from the cassette and convey it in an oblique orientation to the worktable. The probe unit faces the mounting surface of the worktable. Furthermore, the Publication includes a description of reducing the area occupied by the cassette accommodating the substrates at an oblique angle of 65° to 80° with respect to a horizontal surface and preventing deformation of the substrates.

Japanese Unexamined Patent Application, Publication No. 2001-291765 discloses a substrate storage box and a processing system. The substrate storage box has an inner space capable of accommodating one substrate to be processed in an air-tight manner and includes a case whose inner space has an upper surface, a side surface, and a bottom surface, one of which is openable/closable, and a supporting member provided inside the case in order to support the substrate to be processed in a vertical or oblique orientation. Furthermore, the Publication includes a description of a moving system that obliquely holds the substrates inside a dustproof substrate storage box.

Japanese Unexamined Patent Application, Publication No. HEI-11-199007 discloses a conveying method for a cassette and processing equipment. In the processing equipment, a stocker for accommodating a cassette and a processing equipment having a loader unit are provided facing each other on both sides of a rail for guiding the movement of a stacker crane having a moving device. In addition, the stocker, the stacker crane, and only the loader unit of the processing equipments are disposed inside the main body of the clean room. Furthermore, the Publication includes a description of providing stockers at loader units of processing equipments disposed in series and providing clean rooms only for the loader units.

Patent Document 1: Japanese Unexamined Patent Application, Publication No. 2005-235904
Patent Document 2: Japanese Unexamined Patent Application, Publication No. HEI-08-139153
Patent Document 3: Japanese Unexamined Patent Application, Publication No. HEI-10-123193
Patent Document 4: Japanese Unexamined Patent Application, Publication No. 2001-291765
Patent Document 5: Japanese Unexamined Patent Application, Publication No. HEI-11-199007

### Disclosure of Invention

As described above, the thin-film solar-cell manufacturing system described in Japanese Unexamined Patent Application, Publication No. 2005-235904 includes a plurality of substrate cassettes for temporarily storing the substrates. However, there are the following problems when a plurality of substrate cassettes, corresponding to the manufacturing steps and the processing equipments, are provided. In other words, a number of substrate cassettes corresponding to the maximum number of substrates to be stored in the manufacturing steps and the processing equipments is required, and the substrate cassettes thus become large, or many substrate cassettes must be provided. As a result, the area where the substrate cassettes are disposed increases and takes up a large amount of the factory space. Moreover, since many substrate cassettes need to be managed, management becomes complicated, causing an increase in costs. Moreover, the loading and unloading of substrates to and from the processing equipments becomes complicated when using only a common stocker accommodating all of the substrates being processed, and confusion in the processing steps may occur. In other words, one issue is to construct a system that can easily and accurately function when processing equipments and groups of processing equipments whose processing speeds and operation times, based on maintenance cycles, are interspersed and not standardized are arranged and used as a manufacturing line.

In particular, for large substrates (for example, 1.1 m × 1.4 m × 4 mm^{t}), the distance between horizontally stored substrates in a cassette must be 30 to 50 mm or more when bending of the substrates (for example, bending is approximately 5 mm at the center of a glass substrate of 4 mm^{t} supported over a width of 1.1 m) and loading and unloading of the substrates are taken into consideration. Therefore, the size of the substrate cassette must be increased, and the installation space for each manufacturing step in a factory increases.

The present invention has been conceived in light of such problems, and an object of the present invention is to provide a thin-film solar-cell manufacturing system that enables the installation space in the factory to be reduced.

Another object of the present invention is to provide a common substrate storage rack for thin-film solar-cell manufacturing that enables the size and the installation space in the factory to be reduced.

Another object of the present invention is to provide a thin-film solar-cell manufacturing system and a common substrate storage rack that function as buffers for substrate accumulation and that are capable of responding flexibly to changes in delayed manufacturing steps.

To achieve the objects described above, the present invention provides the following solutions.
A thin-film solar-cell manufacturing system according to a first aspect of the present invention comprises a first common substrate storage rack for accommodating substrates tilted from the vertical direction; and a plurality of processing equipments that process the substrates in manufacturing steps of thin-film solar cells and that are arranged to unload the processed substrates to the first common substrate storage rack. The first common substrate storage rack is shared by the plurality of processing equipments and accommodates the substrates regardless of the processing order of the manufacturing steps.

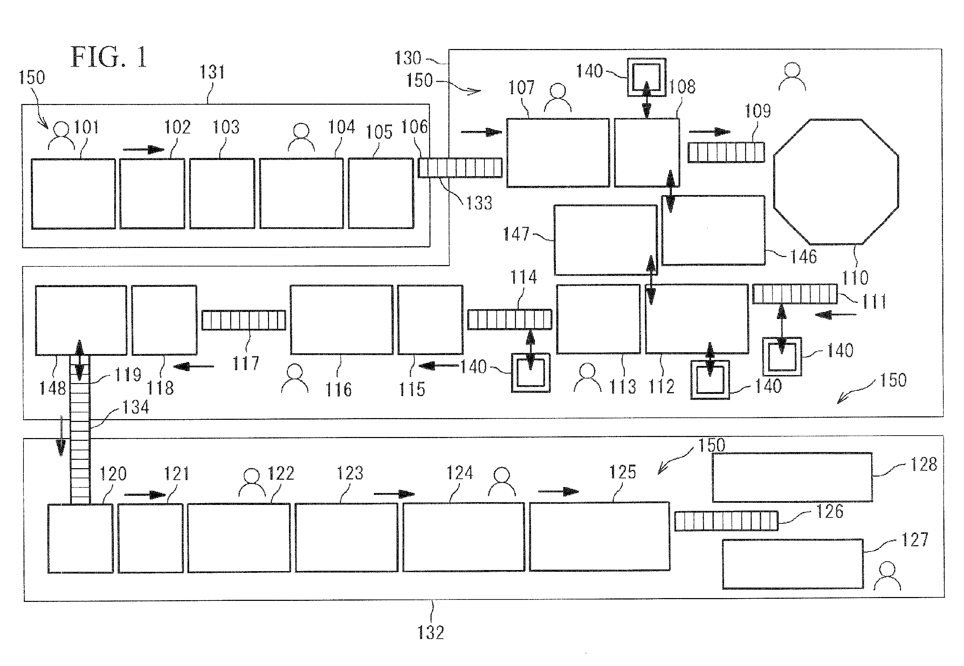

With the thin-film solar-cell manufacturing system according to the first aspect of the present invention, by appropriately providing the first common substrate storage rack which accommodates the substrates regardless of the processing order of the manufacturing steps, at least some of the processing equipments can be arranged in series by using the first common substrate storage rack. In this way, the thin-film solar-cell manufacturing system can be used in thin-film solar-cell manufacturing and can reduce the factory construction cost.
Moreover, with the thin-film solar-cell manufacturing system according to the first aspect of the present invention, the common substrate storage rack is shared by the processing equipments to accommodate the substrates. In other words, the common substrate storage racks are not used for specific processing equipments but are shared by a plurality of processing equipments. In this way, the numbers of substrates stored in the common substrate storage racks do not have to correspond to the maximum number required by the processing equipments, and thus the common substrate storage racks can be efficiently used, and the size can be reduced. As a result, the entire installation space is significantly reduced compared with the storage space of the substrate cassettes installed in an S-shaped snake-like line, as shown in the related art in Fig. 1.

The above-described thin-film solar-cell manufacturing system may include a second common substrate storage rack for accommodating substrates tilted from the vertical direction; and a substrate-processing control device for controlling the processing order of the substrates. The plurality of processing equipments may be disposed in a region between the first common substrate storage rack and the second common substrate storage rack, the plurality of processing equipments being arranged such that one of substrate loaders and substrate unloaders face the first common substrate storage rack and the other face the second common substrate storage rack. The first common substrate storage rack and the second common substrate storage rack may be shared by the plurality of processing equipments. The substrate-processing control device may control loading and unloading of the substrates to and from at least some of the processing equipments and control the loading and unloading of the substrates to and from the first common substrate storage rack and the second common substrate storage rack.

With the above-described thin-film solar-cell manufacturing system, two common substrate storage racks are shared by the plurality of processing equipments to accommodate the substrates. In other words, the two common substrate storage racks are not used for specific processing equipments but are shared by a plurality of processing equipments. In this way, the numbers of substrates stored in the common substrate storage racks do not have to correspond to the maximum number required by the processing equipments, and thus the common substrate storage racks can be efficiently used, and the size can be reduced. As a result, the entire installation space is significantly reduced compared with the storage space of the substrate cassettes installed in an S-shaped snake-like line, as shown in the related art in Fig. 1.

With the above-described thin-film solar-cell manufacturing system, since the two common substrate storage racks and the plurality of processing equipments are disposed such that the loaders and unloaders face each other, the moving distances of the substrate can be significantly reduced. In this way, an increase in space for the moving path required for moving the substrates can be significantly suppressed. Furthermore, since the moving distance is short, the moving time can be reduced, thus improving throughput efficiency. The processing equipments have separate loaders and unloaders and form an assembly line in which substrates enter from one side and exit from the other side. Since two common substrate storage racks are on both sides, the substrates can be temporarily stored in an extremely efficient manner.

Here, when two units "face each other", they are disposed substantially opposite to each other, and a device for moving the substrates, such as a substrate moving device, or a device for changing the orientation of the substrates may be provided. The substrates may not only be unprocessed substrates but also substrates processed in various ways by the processing equipments. Each of the processing equipments is not limited to a single equipment unit and may be a group of equipments performing a processing sequence or a group of equipments having a substrate conveying path. "To share" may be to use the same substrate storage space in each of the two common substrate storage racks by different processing equipments.

According to Patent Document 1, a substrate cassette is provided for each processing equipment, and a common substrate storage rack, such as that according to the present invention shared by processing equipments, is not used. Therefore, compared with the present invention, the installation space is large.

According to Patent Document 2, it is not mentioned whether a cassette is shared so that the same substrate storage space can be used by different processing equipments. Since the cassette is not disposed facing the processing equipments, extra space for a moving path (rail) is required for moving the substrates. In addition, since the cassette is disposed only on one side of the processing equipments, not both sides, the equipments cannot be used in an assembly line.

According to Patent Document 3, since there is one processing equipment, a configuration in which a plurality of processing equipments share a cassette is not described. Since the cassette is disposed only on one side of the processing equipments, not both sides, the equipments cannot be used in an assembly line.

According to Patent Document 4, it is not mentioned whether or not a cassette station is shared so that the same substrate storage space can be used by different processing equipments. Also, since the cassette station does not face the processing equipments, when a substrate is moved to a processing equipment far away from the cassette station, the moving distance becomes long. In addition, since the cassette is disposed only on one side of the processing equipments, not both sides, the equipments cannot be used in an assembly line.

According to Patent Document 5, it is not mentioned whether or not a stocker is shared so that the same substrate storage space can be used by different processing equipments. In addition, since the cassette is disposed only on one side of the processing equipments, not both sides, the equipments cannot be used in an assembly line.

In the above-described thin-film solar-cell manufacturing system, at least some of the plurality of processing equipments may be arranged in series with each other via the first common substrate storage rack or the second common substrate storage rack, and the arrangement order of at least some of the plurality of processing equipments may not follow the manufacturing steps of the thin-film solar cells.
Shared by the plurality of processing equipments and by using the common substrate storage racks installed in the periphery of the processing equipments, the plurality of processing equipments can be arranged at positions appropriate to their placement in the thin-film solar-cell manufacturing factory, not according to the order of the thin-film solar-cell manufacturing steps. This is because at least some of the processing equipments can be arranged in series with each other by sharing the common substrate storage racks, and thus the substrates can be unloaded wherever they are stored, regardless of the arrangement order of the processing equipments. Accordingly, the substrates can be efficiently conveyed to the processing equipment for the next processing step. Since at least some of the plurality of processing equipments are disposed in series, the gaps between the processing equipments are used as a common maintenance space. Therefore, the maintenance space can be reduced at the same time.

With the above-described thin-film solar-cell manufacturing system, the order of the manufacturing steps of the thin-film solar cells of at least some of the plurality of processing equipments may be changed by the substrate-processing control device, without changing the arrangement order of the plurality of processing equipments.
In other words, even when there is a change in the order of some of the manufacturing steps of the thin-film solar cell, the processing equipments corresponding to the changed processing steps do not have to be moved/reinstalled; rather, the order of the manufacturing steps can be changed by changing the control program of the substrate-processing control device.

With the above-described thin-film solar-cell manufacturing system, it is preferable that each of the plurality of processing equipments be arranged at a region assigned on the basis of the height of the plurality of processing equipment.
By arranging the plurality of processing equipments in a region assigned based on the height, from the floor, of the plurality of processing equipments and not in the order of the manufacturing steps of the thin-film solar cells, the space surrounding the plurality of processing equipments can be efficiently used. For example, space in the factory can be efficiently used by closely arranging lower processing equipments and lowering the ceiling at the space above these processing equipments and by arranging equipments for other processing steps on a second floor constructed in the space above. In this way, the construction costs of the factory building can be reduced.

With the above-described thin-film solar-cell manufacturing system, it is preferable that each of the plurality of processing equipments be arranged in a region assigned on the basis of the utility to be used by the processing equipment.
By arranging the plurality of processing equipments in a region assigned based on the utilities used by the plurality of processing equipments and not in the order of the manufacturing steps of the thin-film solar cells, piping and wiring associated with the utilities can be shortened and simplified and thus can be used safely.

With the above-described thin-film solar-cell manufacturing system, it is preferable that the first common substrate storage rack include a first cleaning device for maintaining the cleanliness level of an inner atmosphere at a cleanliness level higher than an outside atmosphere. Furthermore, it is preferable that the second common substrate storage rack include a second cleaning device for maintaining the cleanliness level of the inner atmosphere at a cleanliness level higher than the outside atmosphere.
Since each of the two common substrate storage racks includes a cleaning device, the cleanliness level of the inner atmosphere of the racks can be maintained higher than that of the outside atmosphere. Since the capacity of the two common substrate storage racks is limited, a large amount of ventilation flow is not required for the cleaning devices. As a result, the cleanliness level of the substrates can be maintained at a significantly high level at low cost.

It is preferable that the above-described thin-film solar-cell manufacturing system further includes a first chamber, a third cleaning device, a second chamber, and a fourth cleaning device. The first chamber includes a space between the first common substrate storage rack and the plurality of processing equipments. The third cleaning device maintains the cleanliness level of an atmosphere inside the first chamber at a cleanliness level higher than an atmosphere in other regions. The second chamber includes a space between the second common substrate storage rack and the plurality of processing equipments. The fourth cleaning device maintains the cleanliness level of an atmosphere inside the second chamber at a cleanliness level higher than an atmosphere in other regions.
Since the space between the common substrate storage racks and the processing equipments is covered by the first chamber and the second chamber and cleaned with the cleaning devices, both chambers can be maintained at a high cleanliness level. As a result, the cleanliness level can be maintained higher than that of the common substrate storage racks. In this way, strict management, such as constructing the entire factory as a clean room, is not required, and the cost of the factory can be reduced. Moreover, since each processing equipment in the factory can be arranged in a normal atmosphere outside the clean room, special work management involving wearing lint-free clothes is not required. In particular, the operability during maintenance can be improved, thus improving productivity. Since the space in which a clean environment needs to be maintained can be limited, and operating costs, such as the power for fans used to ventilate the HEPA filter of the clean room, can be significantly reduced.

It is preferable that the above-described thin-film solar-cell manufacturing system further includes a first substrate moving device and a second substrate moving device. The first substrate moving device moves the substrates inside the first chamber. The second substrate moving device moves the substrates inside the second chamber. In this case, it is preferable that the first substrate moving device include a fifth cleaning device for maintaining the cleanliness level of the inside atmosphere at a cleanliness level higher than the outside atmosphere. It is preferable that the second substrate moving device include a sixth cleaning device for maintaining the cleanliness level of the inside atmosphere at a cleanliness level higher than the outside atmosphere.
By using the first substrate moving device including the fifth cleaning device and the second substrate moving device including the sixth cleaning device, the substrates can be kept clean even when they are being moved.

With the above-described thin-film solar-cell manufacturing system, it is preferable that the tilt of the substrates being stored be between 5° or larger and 15° or smaller from the vertical direction.
When the substrates are stored while tilted from the vertical direction, it is preferable that the substrates be tilted at an angle of 5° or larger from the vertical direction in order to stably hold the substrates by their own weight, and it is preferable that the substrates be tilted from the vertical direction at an angle 15° or smaller so as to reduce the space of the devices. At this time, the bending of the substrates at the above-described tilted angle is reduced to approximately 1/10 of that when the substrate is horizontal. In this way, the distance between substrates loaded in the common substrate storage racks can be reduced to, for example, approximately 30 mm from approximately 50 mm, which is the distance when the substrates are horizontal. As a result, the installation space of the common substrate storage racks can be reduced by approximately 20% compared to the case when the substrates are horizontal.

With the above-described thin-film solar-cell manufacturing system, it is preferable that each of the first common substrate storage rack and the second common substrate storage rack each include a plurality of substrate storage racks. It is preferable that the plurality of substrate storage racks be replaceable by other substrate storage racks that are of the same configuration as the plurality of substrate storage racks.
When one substrate storage rack is filled with substrates that are in the middle of processing steps, the substrate storage rack may be moved to another storage space by being removed with a ceiling crane or a forklift. Then, an empty substrate storage rack can be inserted in its place. In this way, if one of the substrate storage racks is filled and is unable to accommodate subsequent substrates, other substrate storage racks can be used instead, and flexible operation becomes possible.

The above-described thin-film solar-cell manufacturing system may include a substrate conveyer that is provided between the first common substrate storage rack and the second common substrate storage rack, the substrate conveyer maintaining the cleanliness level of the inside atmosphere at a cleanliness level higher than the outside atmosphere and moving the substrates from one of the first common substrate storage rack and the second common substrate storage rack to the other.
Since the substrates can be moved between the first common substrate storage rack and the second common substrate storage rack in an atmosphere with a high cleanliness level, the substrates can be kept cleaner. By using the substrate moving device, not only it is possible to share the substrate storage space in the first common substrate storage rack but it is also possible to substantially share the substrate storage space included in the second common substrate storage rack. As a result, the flexibility of the substrate storage space can be improved, and even when the amount of margin in substrate storage in the first common substrate storage rack and the second common substrate storage rack is reduced, appropriate operation can be carried out, and the factory construction cost can be reduced. A plurality of substrate conveyers may be provided.

A common substrate storage rack according to a second aspect of the present invention includes a plurality of substrate storage racks and a plurality of cleaning devices. The plurality of substrate storage racks accommodate substrates tilted from the vertical direction and is provided in series in a direction different from the loading and unloading direction of the substrates. The plurality of cleaning devices are provided for the respective substrate storage racks, each cleaning device supplying air of a cleanliness level higher than the cleanliness level of ambient atmosphere to the corresponding substrate storage rack. One of substrate loaders and substrate unloaders of the plurality of processing equipments that are used in manufacturing steps of thin-film solar cells face the plurality of substrate storage racks and are disposed such as to be shared by the plurality of processing equipments. Each of the plurality of substrate storage racks is replaceable by other substrate storage rack that is of the same configuration as each of the plurality of substrate storage racks.

With the above-described common substrate storage rack, each of the substrate storage racks includes a cleaning device and an opening mechanism. In this way, the substrates can be kept clean. The substrates are tilted from the vertical direction, warpage of the substrates caused by the substrates' own weight is smaller than that when the substrates are in a horizontal orientation, and the substrate installation positions can be maintained by the substrates' own weight more stably than a vertical orientation, even in a small space. Therefore, installation area can be significantly reduced. Since the substrate storage rack and the plurality of processing equipments are disposed such that their loaders or unloaders face, the moving distance of the substrates can be significantly reduced. In this way, an increase in space for the moving path required for moving the substrates can be significantly suppressed, and the takt time required for substrate storage processing can be reduced.

A third aspect of the present invention is a method of manufacturing thin-film solar cells using a thin-film solar-cell manufacturing system. The thin-film solar-cell manufacturing system includes a first common substrate storage rack, a second common substrate storage rack, and a plurality of processing equipments. The first common substrate storage rack and the second common substrate storage rack accommodate substrates while tilting the substrates from the vertical direction. The plurality of processing equipments process the substrates in manufacturing steps of thin-film solar-cells and are disposed in a region between the first common substrate storage rack and the second common substrate storage rack such that one of substrate loader and substrate unloaders face the first common substrate storage rack and the other face the second common substrate storage rack. Furthermore, a substrate-processing control device for controlling the processing order of the substrates is included. The first common substrate storage rack and the second common substrate storage rack are shared by the plurality of processing equipments, and the substrate-processing control device controls loading and unloading of the substrates to and from at least some of the plurality of processing equipments and controls the loading and unloading of the substrates to and from the first common substrate storage rack and the second common substrate storage rack.
The method of manufacturing thin-film solar cells includes the steps of (a) unloading substrates accommodated in the first common substrate storage rack or the second common substrate storage rack and loading the substrates to one of the corresponding processing equipments among the plurality of processing equipments; (b) processing the loaded substrates with the corresponding processing equipment; and (c) unloading the processed substrates from the corresponding processing equipment , loading, and storing the substrates in the first common substrate storage rack or the second common substrate storage rack.

With the above-described method of manufacturing thin-film solar cells, two common substrate storage racks are shared by the plurality of processing equipments to accommodate the substrates. In this way, the numbers of substrates accommodated in the common substrate storage racks do not have to correspond to the maximum number required by the processing equipments, and thus the common substrate storage racks can be efficiently used, and the size can be minimized. Since the two common substrate storage racks and the plurality of processing equipments are disposed such that their loaders or unloaders face, the moving distance of the substrates can be significantly reduced. In this way, an increase in space for the moving path required for moving the substrates can be significantly suppressed. Furthermore, since the moving distance is short, the moving time can be reduced, thus improving work efficiency. At least some of the processing equipments have separate loaders and unloaders and form a line in which substrates enter from one side and exit from the other side. Since two common substrate storage racks are on both sides, the loading direction and the unloading direction do not have to be restricted, and the substrates can be temporarily stored in an efficient manner.

With the above-described thin-film solar-cell manufacturing system, installation space in the factory can be reduced, and the maintainability of the processing equipments can be improved. With the above-described substrate storage rack, the size and the installation space of the substrate storage rack can be reduced, and a clean environment can be easily maintained. By functioning as a buffer for substrate accumulation, flexible operation responding to changes in the accumulation that occur during the manufacturing steps is possible. The takt time required for a substrate storage process can be shortened, and the production efficiency can be increased.

### Brief Description of Drawings

[FIG. 1] Fig. 1 is a structural diagram illustrating an example of a thin-film solar-cell manufacturing system according to the related art.
[FIG. 2] Fig. 2 is a structural diagram illustrating a substrate cassette according to the related art.
[FIG. 3] Fig. 3 is a structural diagram illustrating a thin-film solar-cell manufacturing system according to an embodiment.
[FIG. 4A] Fig. 4A is a schematic view of a manufacturing step of a thin-film solar cell using the thin-film solar-cell manufacturing system.
[FIG. 4B] Fig. 4B is a schematic view of a manufacturing step of a thin-film solar cell using the thin-film solar-cell manufacturing system.
[FIG. 4C] Fig. 4C is a schematic view of a manufacturing step of a thin-film solar cell using the thin-film solar-cell manufacturing system.
[FIG. 4D] Fig. 4D is a schematic view of a manufacturing step of a thin-film solar cell using the thin-film solar-cell manufacturing system.
[FIG. 4E] Fig. 4E is a schematic view of a manufacturing step of a thin-film solar cell using the thin-film solar-cell manufacturing system.
[FIG. 4F] Fig. 4F is a schematic view of a manufacturing step of a thin-film solar cell using the thin-film solar-cell manufacturing system.
[FIG. 4G] Fig. 4G is a schematic view of a manufacturing step of a thin-film solar cell using the thin-film solar-cell manufacturing system.
[FIG. 4H] Fig. 4H is a schematic view of a manufacturing step of a thin-film solar cell using the thin-film solar-cell manufacturing system.
[FIG. 4I] Fig. 4I is a schematic view of a manufacturing step of a thin-film solar cell using the thin-film solar-cell manufacturing system.
[FIG. 5A] Fig. 5A is a schematic view of a manufacturing step of a thin-film solar cell using the thin-film solar-cell manufacturing system.
[FIG. 5B] Fig. 5B is a schematic view of a manufacturing step of a thin-film solar cell using the thin-film solar-cell manufacturing system.
[FIG. 5C] Fig. 5C is a schematic view of a manufacturing step of a thin-film solar cell using the thin-film solar-cell manufacturing system.
[FIG. 5D] Fig. 5D is a schematic view of a manufacturing step of a thin-film solar cell using the thin-film solar-cell manufacturing system.
[FIG. 5E] Fig. 5E is a schematic view of a manufacturing step of a thin-film solar cell using the thin-film solar-cell manufacturing system.
[FIG. 5F] Fig. 5F is a schematic view of a manufacturing step of a thin-film solar cell using the thin-film solar-cell manufacturing system.
[FIG. 6A] Fig. 6A is a schematic view of the configuration of a common substrate storage rack according to this embodiment.
[FIG. 6B] Fig. 6B is a schematic view of the configuration of the common substrate storage rack according to this embodiment.
[FIG. 7A] Fig. 7A is a schematic view of an example of use of the common substrate storage rack according to this embodiment.
[FIG. 7B] Fig. 7B is a schematic view of an example of the use of the common substrate storage rack according to this embodiment.
[FIG. 8] Fig. 8 is a perspective view of the configuration of a substrate storage rack according to this embodiment.
[FIG. 9] Fig. 9 is a schematic view of the substrate storage rack when a substrate is being supported.
[FIG. 10] Fig. 10 is a perspective view of an opening mechanism of the substrate storage rack according to this embodiment.
[FIG. 11] Fig. 11 is a top view of the opening mechanism of the substrate storage rack according to this embodiment.
[FIG. 12] Fig. 12 is a perspective view of the configuration of a substrate moving device according to this embodiment.
[FIG. 13] Fig. 13 is a perspective view of the operation of lower-substrate supporting rollers according to this embodiment.
[FIG. 14A] Fig. 14A is a schematic view of the substrate moving device when a substrate is being supported.
[FIG. 14B] Fig. 14B is a schematic view of the substrate moving device when the substrate is being moved.
[FIG. 15A] Fig. 15A is a schematic view of the lower-substrate supporting rollers when the substrate is being supported or moved.
[FIG. 15B] Fig. 15B is a schematic view of the lower-substrate supporting rollers when the substrate is being grabbed.
[FIG. 16] Fig. 16 is a perspective view of another configuration of a substrate moving device according to this embodiment.
[FIG. 17] Fig. 17 is a perspective view of another configuration of a substrate moving device according to this embodiment.
[FIG. 18] Fig. 18 is a perspective view of the configuration of a substrate moving device according to this embodiment.

### Explanation of Reference Signs:

1: substrate loading device
2: substrate cleaner
4: transparent-electrode depositing equipment (thermal CVD equipment)
7: TCO (transparent electrode) laser etching equipment
8: substrate cleaner
9: substrate conveyer
10: photoelectric-conversion-layer depositing equipment (plasma CVD equipment)
12: photoelectric-conversion-layer laser etching equipment 13: back surface electrode depositing equipment (sputtering equipment)
15: substrate cleaner
16-1: back surface laser etching equipment
16-2: insulation laser etching equipment
17: substrate-processing control device 20-1, 20-1, 22: region
30: thin-film solar-cell manufacturing system 30-1, 30-2: boundary (side surface)
40, 40-1, 40-2: common substrate storage rack 41, 41a to 41g: substrate storage rack
42: filter device
43: upper-substrate supporting roller
43a: roller
44: lower-substrate supporting roller
44a: roller
44b: depressed section
45: case
46: opening mechanism
47: sheet
48, 48-1, 48-2: sheet storage section
49: open section
50: moving rail
51: substrate moving device
52: filter device
53: upper-substrate supporting roller
53a: roller
54: lower-substrate supporting roller
54a, 54b, 54b-1, 54b-1', 54b-2, 54b-2': member
54c: roller
54c-1, 54c-2: roller member
54e: depressed section
54f: roller driving section
55: clean bench
56: mover moving device
57: mover-section vertical-moving device
58: mover-section supporting base
61: substrate moving device
62: filter device
63: substrate-side supporting roller
64: substrate-side supporting roller
65: clean bench
66: mover moving device
67: mover-section vertical-moving device
68: mover-section supporting base
69: moving-section roller
70: moving rail
72: filter device
73: upper-substrate supporting roller
74: lower-substrate supporting roller
75: clean bench
81: substrate
82: transparent electrode layer
83: photoelectric conversion layer
84: back surface electrode layer
85: solar cell
86: module
90, 91, 92: separation groove
94: peripheral region
95: insulation groove
97: cover sheet
98: terminal box
200: gas related facility

### Best Mode for Carrying Out the Invention

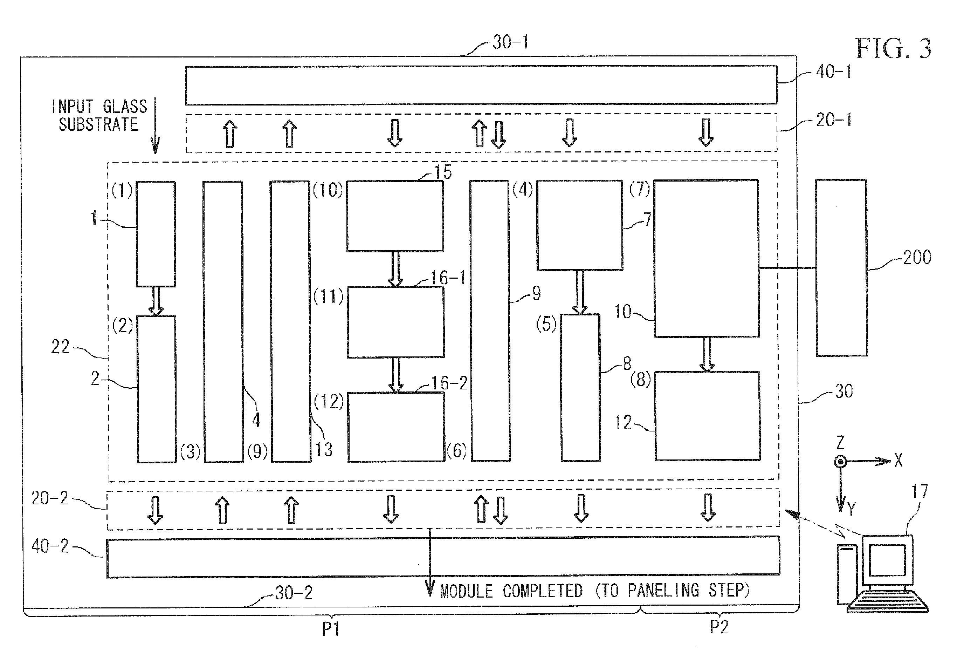

An embodiment of the present invention will be described below with reference to the drawings. Fig. 3 is a structural diagram of a thin-film solar-cell manufacturing system according to this embodiment. A thin-film solar-cell manufacturing system 30 is installed inside a thin-film solar-cell factory and is for manufacturing thin-film solar cells, such as amorphous solar cells and tandem solar cells, on substrates, such as transparent glass substrates. The thin-film solar-cell manufacturing system 30 includes a plurality of processing equipments and common substrate storage racks 40 (40-1 and 40-2) installed in a room with a normal atmosphere.

The plurality of processing equipments is used in the manufacturing steps of thin-film solar cells. As an example of the plurality of processing equipments used up to the module manufacturing step, it is provided with a substrate loading device 1, a substrate cleaner 2, a transparent-electrode depositing equipment (thermal CVD equipment) 4, a TCO (transparent electrode) laser etching equipment 7, a substrate cleaner 8, a substrate conveyer 9, a photoelectric-conversion-layer depositing equipment (plasma CVD equipment) 10, a photoelectric-conversion-layer laser etching equipment 12, a back surface electrode depositing equipment (sputtering equipment) 13, a substrate cleaner 15, a back surface laser etching equipment 16-1, and an insulation laser etching equipment 16-2. These processing equipments are arranged such that the processing equipments used in each manufacturing step and groups of the processing equipments used in consecutive steps are generally aligned in series in an area 22 flanked by the common substrate storage racks 40-1 and 40-2. Each of the processing equipments may be a combination of equipments used for performing a processing sequence.

The common substrate storage racks 40-1 and 40-2 are buffers commonly used by each of the processing equipments to absorb substrate accumulation. The common substrate storage racks 40-1 and 40-2 are provided along two boundaries (side surfaces) 30-1 and 30-2 facing the area where the thin-film solar-cell manufacturing system 30 is disposed. In other words, the common substrate storage racks 40-1 and 40-2 are disposed around the groups of processing equipments such that they face the substrate loader and unloader of each of the processing equipments. Designated areas (fixed areas) for storing substrates processed at specific processing equipments are not provided for the common substrate storage racks 40-1 and 40-2; instead, the racks are shared by all of the processing equipments. Not only substrates that are not yet processed but also substrates that have been processed by the processing equipments will be referred to as "substrates".

The loading and unloading of the substrates to and from the common substrate storage racks 40-1 and 40-2 and the processing equipments are performed by substrate moving devices (described below) that operate mainly while moving in the X direction in areas 20-1 and 20-2. The areas 20-1 and 20-2 are areas between the area 22 and the common substrate storage racks 40-1 and 40-2, respectively. The substrate moving devices are not for specific processing equipments and can be shared by all processing equipments. One or more substrate moving devices may be provided for each of the areas 20-1 and 20-2.

The processing order of the substrates is controlled by a substrate-processing control device 17. The substrate-processing control device 17 controls the loading and unloading of substrates to and from at least some of the processing equipments and controls the loading and unloading of substrates to and from the first common substrate storage rack 40-1 and the second common substrate storage rack 40-2. Furthermore, the substrate-processing control device 17 links the substrate moving devices, links each of the substrate moving devices with each of the processing equipments, and is controlled by a control program installed in a computer (not shown) for controlling the substrate-processing control device 17. In the substrate-processing control device 17, transmission and reception of information and commands between the substrate moving devices, between the substrate moving devices and the processing equipments, and among the substrate moving devices, the processing equipments, and the computer can be performed, for example, via a wireless LAN in the thin-film solar-cell manufacturing system 30. The control program may store the substrate positions (including storage positions) and loading and unloading of substrates to and from the common substrate storage racks 40 in a recording area exclusively used for the control computer. Furthermore, substrate IDs of the substrates may be used for management. The substrate IDs may be used in the processing steps of the processing equipments and for quality control of the processed substrates in association with intermediate inspection steps. The substrate IDs may be read by reading devices provided in the substrate moving devices and sent to the computer so as to confirm the loading and/or unloading to and from the common substrate storage racks 40.

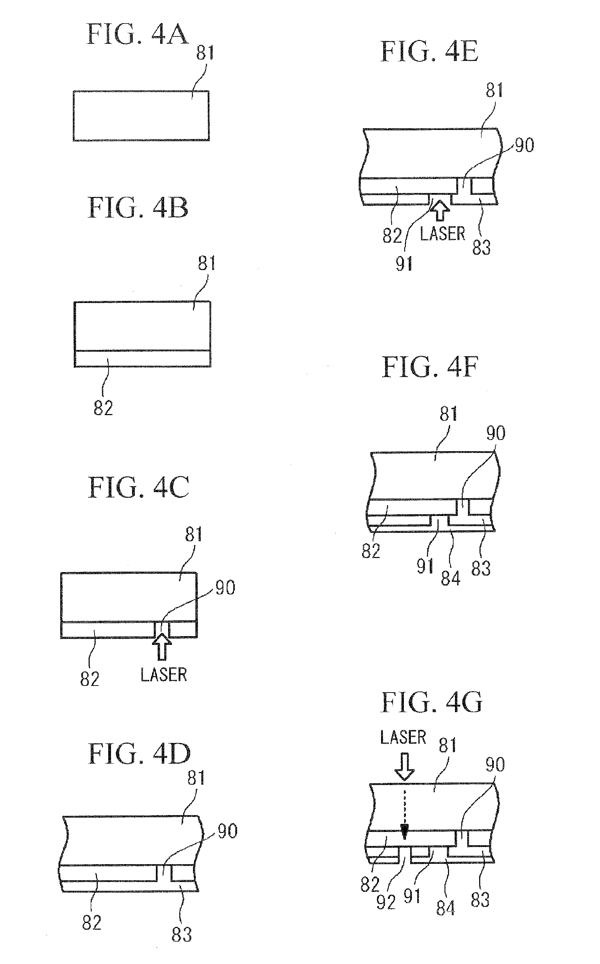

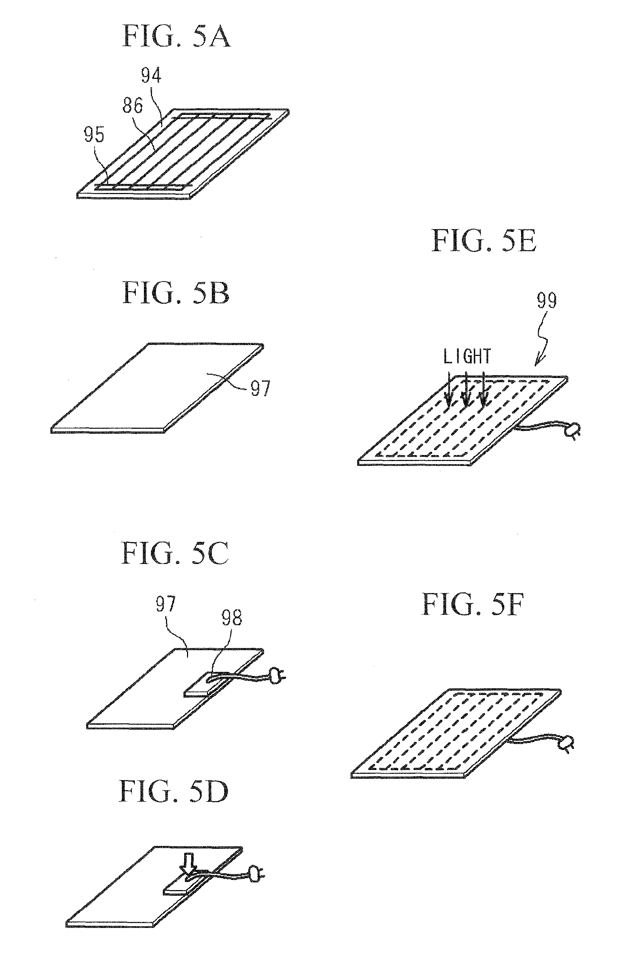

The association of the processing equipments with the manufacturing steps of the thin-film solar cell will be described. Figs. 4A to 4H and 5A to 5F are schematic views of the manufacturing steps of the thin-film solar cell using the thin-film solar-cell manufacturing system. First, a thin-film solar cell in the main steps of thin-film solar-cell manufacturing is described with reference of Figs. 4A to 4H and 5A to 5F. Here, the modular-forming step includes the following steps (A) to (H), which are shown in Figs. 4A to 4H, respectively:
(A) Fig. 4A: receiving and cleaning a substrate 81;
(B) Fig. 4B: depositing a transparent electrode layer 82 on the substrate 81;
(C) Fig. 4C: forming separation grooves 90 by laser etching the transparent electrode layer 82, and cleaning;
(D) Fig. 4D: depositing a photoelectric conversion layer 83 on the transparent electrode layer 82;
(E) Fig. 4E: forming separation grooves 91 by laser etching the photoelectric conversion layer 83, and cleaning;
(F) Fig. 4F: depositing a back surface electrode layer 84 on the photoelectric conversion layer 83;
(G) Fig. 4G: forming separation grooves 92 by laser etching the photoelectric conversion layer 83 and the back surface electrode layer 84, and cleaning; and

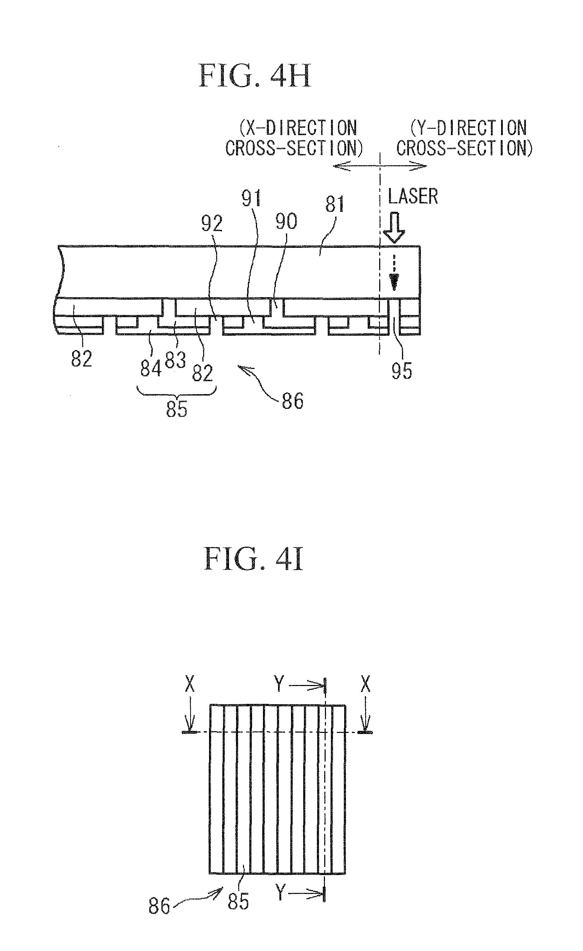

(H) Fig. 4H: forming insulation grooves 95 by laser etching the transparent electrode layer 82, the photoelectric conversion layer 83, and the back surface electrode layer 84, cleaning, and completing a module 86.

The paneling step includes the following steps (I) to (N), as shown in Figs. 5A to 5F:
(I) Fig. 5A: removing the transparent electrode layer 82, the photoelectric conversion layer 83, and the back surface electrode layer 84 in a peripheral area 94, and cleaning;
(J) Fig. 5B: bonding a cover sheet 97;
(K) Fig. 5C: attaching a terminal box 98;
(L) Fig. 5D: injecting sealant;
(M) Fig. 5E: inspecting power generation; and
(N) Fig. 5F: completing the thin-film solar cell panel.

The relationship between the processing equipments and the common substrate storage racks 40 in the manufacturing steps of the thin-film solar cell and the flow of a substrate is described below with reference to Figs. 3 to 5F.
(A) The substrate is received by the substrate loading device 1 ((1) in Fig. 3). Next, the substrate is cleaned at the substrate cleaner 2 ((2) in Fig. 3 and Fig. 4A). The substrate is unloaded from the substrate cleaner 2 by the substrate moving device and is loaded into the common substrate storage rack 40-2.
(B) The substrate is unloaded from the common substrate storage rack 40-2 by the substrate moving device and is loaded into the transparent-electrode depositing equipment (thermal CVD equipment) 4. Then, the transparent electrode layer 82 is deposited on the substrate at the transparent-electrode depositing equipment 4 ((3) in Fig. 3 and Fig. 4B). The substrate is unloaded from the transparent-electrode depositing equipment 4 by the substrate moving device and is loaded into the common substrate storage rack 40-1.
(C) The substrate is unloaded from the common substrate storage rack 40-1 and is loaded into the TCO (transparent electrode) laser etching equipment 7. Then, the separation grooves 90 are formed in the transparent electrode layer 82 by laser etching performed by the TCO laser etching equipment 7 ((4) in Fig 3 and Fig 4C). In this way, the transparent electrode layer 82 is separated into strips. Subsequently, the substrate is cleaned by the substrate cleaner 8 ((5) in Fig. 3). The substrate is unloaded from the substrate cleaner 8 by the substrate moving device and is loaded into the common substrate storage rack 40-2. Otherwise, the substrate is unloaded from the substrate cleaner 8, is loaded into the substrate conveyer 9 by the substrate moving device, is conveyed by the substrate conveyer 9 ((6) in Fig. 3), is unloaded by the substrate conveyer 9 by the substrate moving device, and is loaded into the common substrate storage rack 40-1.
(D) The substrate is unloaded from the common substrate storage rack 40-1 by the substrate moving device and is loaded into the photoelectric-conversion-layer depositing equipment (plasma CVD equipment) 10. Then, the photoelectric conversion layer 83 is deposited on the transparent electrode layer 82 by the photoelectric-conversion-layer depositing equipment 10 ((7) in Fig. 3 and Fig. 4D). The photoelectric conversion layer 83 is normally deposited of semiconductor layers, i.e., a p layer, an i layer, and an n layer. When the photoelectric conversion layer 83 is a tandem type, the substrate is unloaded from the common substrate storage rack 40-2, is loaded into the substrate conveyer 9 by the substrate moving device, is conveyed by the substrate conveyer 9 ((6) in Fig. 3), is unloaded from the substrate conveyer 9 by the substrate moving device, and is loaded into the photoelectric-conversion-layer depositing equipment (plasma CVD equipment) 10. Then, the photoelectric conversion layer 83, which is the bottom layer of the tandem type solar cell, is deposited by the photoelectric-conversion-layer depositing equipment 10 ((7) in Fig. 3 and Fig. 4D).
(E) The separation grooves 91 are formed in the photoelectric conversion layer 83 by laser etching performed by the photoelectric-conversion-layer laser etching equipment 12 ((8) in Fig. 3 and Fig. 4E). In this way, the photoelectric conversion layer 83 is separated into strips at positions slightly misaligned from the etching positions of the transparent electrode layer 82. The substrate is unloaded from the photoelectric-conversion-layer laser etching equipment 12 by the substrate moving device and is loaded into the common substrate storage rack 40-2.
(F) The substrate is unloaded from the common substrate storage rack 40-2 by the substrate moving device and is loaded into the back surface electrode depositing equipment (sputtering equipment) 13. Then, the back surface electrode layer 84 is deposited on the photoelectric conversion layer 83 by the back surface electrode depositing equipment 13 ((9) in Fig. 3 and Fig. 4F). The substrate is unloaded from the back surface electrode depositing equipment 13 by the substrate moving device and is loaded into the common substrate storage rack 40-1.
(G) The substrate is unloaded from the common substrate storage rack 40-1 by the substrate moving device and is loaded into the substrate cleaner 15. Then, the substrate is cleaned at the substrate cleaner 15 ((10) in Fig. 3). Subsequently, the separation grooves 92 are formed in the back surface electrode layer 84 and the photoelectric conversion layer 83 via laser etching performed by the back surface laser etching equipment 16-1 ((11) in Fig. 3 and Fig. 4G). In this way, the back surface electrode layer 84 and the photoelectric conversion layer 83 are separated into strips at positions further misaligned from the etching positions, to form the module 86 in which strips of a plurality of solar cells 85 are connected in series.
(H) The insulation grooves 95 are formed in the back surface electrode layer 84, the photoelectric conversion layer 83, and the transparent electrode layer 82 via laser etching performed by the insulation laser etching equipment 16-2 ((12) in Fig. 3 and Fig. 4H). In this way, two opposing sides of the module 86 are isolated. The substrate is unloaded from the insulation laser etching equipment 16-2 by the substrate moving device and is loaded into the common substrate storage rack 40-2. In Fig. 4H, the Y direction is the same direction as the longitudinal direction of the solar cells 85 in the module 86, shown in Fig. 4I, and the X direction is the direction orthogonal to the Y direction.

When there is a device with a short device length included in the processing equipments installed in the space between the common substrate storage racks 40-1 and 40-2, a substrate conveyer having a required length is additionally installed at the loading side or the unloading side of the processing equipment in order to allow substrates to be loaded and unloaded to and from the substrate moving device. For any of the processing equipments whose substrate loading and/or unloading directions do not face the common substrate storage racks 40-1 and 40-2, additional devices for rotating the loading and unloading directions of the substrate are provided.

The substrates can move between the common substrate storage racks 40-1 and 40-2 by the substrate conveyer 9. However, by providing a plurality of substrate conveyers 9, if required, the takt time for moving the substrates can be reduced, thus improving the flexibility of the manufacturing line.

Subsequently, in the paneling step, the processing equipments may be installed in other sections of the factory since the installation atmosphere of the processing equipments may be a usual environment that does not have to be as clean as that required for the modular-forming step. For example, a processing equipment that performs the steps carried out from the film polisher 120 to the performance-sorted storage container 128 of Japanese Unexamined Patent Application, Publication No. 2005-235904 which is shown in Fig. 1, may be installed in a floor above, below, or adjacent to the floor where the modular-forming step shown in Fig. 3 is performed.
(I) The back surface electrode layer 84, the photoelectric conversion layer 83, and the transparent electrode layer 82 in the peripheral area 94 of the substrate removed from a common substrate storage rack 40-2 is removed by polishing carried out by the film polisher 120 (Fig. 5A).
(J) Subsequently, the substrate is cleaned at the substrate cleaner 121, and the cover sheet 97 is bonded to the substrate at the lay-up equipment 122, the laminator 123, and the paneling equipment 124 (Fig. 5B).
(K) Next, a terminal box is attached to the substrate at the terminal-base attaching equipment 125 (Fig. 5C).
(L) The terminal box is filled with sealant (potting agent) and is sealed airtight (Fig. 5D).
(M) Then, the substrate is conveyed by the substrate conveyer 126 to the power-generation inspection equipment 127, where power generation inspection is performed (Fig. 5E).
(N) Then, the substrate is sorted into the performance-sorted storage container 128 as a final product (Fig. 5F).

In the above-described thin-film solar cell manufacturing steps, areas are generally not provided for specific processing equipments in the common substrate storage racks 40-1 and 40-2; instead the areas are shared by a plurality of the processing equipments. Therefore, since the areas do not have to correspond to the maximum number of substrates to be stored by each processing equipment, the volume of the common substrate storage racks 40-1 and 40-2 can be significantly reduced compared with the total volume when a corresponding substrate cassette 140 is added, as shown in Fig. 1. In other words, the common substrate storage racks 40-1 and 40-2 can be used efficiently and can be minimized in size.

As shown in Fig. 3, it is preferable that the processing equipments or the groups of processing equipments be installed in the area 22 such that one of the substrate inlet and the substrate outlet faces the common substrate storage rack 40-1 and the other faces the common substrate storage rack 40-2.
In this way, the substrates unloaded from the common substrate storage racks 40 can be easily loaded into the processing equipments. Furthermore, it is preferable that the processing equipments be positioned substantially orthogonal to the longitudinal direction of the common substrate storage racks 40-1 and 40-2 when the processing equipments are rectangular and have substrate inlets at one end and substrate outlets at the other end. In the example shown in Fig. 3, the processing by the processing equipments or the groups of processing equipments proceeds in the Y direction of the common substrate storage racks 40, which are longer in the X direction.

However, only one of the common substrate storage racks 40-1 and 40-2 need to be positioned this way so long as substrate accumulation does not occur or so long as the substrates do not have to be accumulated at one of the sides facing the common substrate storage racks 40-1 and 40-2. In such a case, at the side not facing the common substrate storage racks 40, the substrate is moved to the next processing equipment by, for example, a substrate moving device (described below).

With the example shown in Fig. 3, a plurality of processing equipments for performing the modular-forming step of a thin-film solar cell, which has a single photoelectric conversion layer, are provided as the thin-film solar-cell manufacturing system 30. However, the present invention is not limited thereto, and the present invention may provide a system for manufacturing tandem thin-film solar cells, which include a plurality of photoelectric conversion layers, or a manufacturing system performing a paneling step. In such cases, additional processing equipments are installed in an area 22 flanked by the common substrate storage racks 40-1 and 40-2, if required.

In the thin-film solar cell manufacturing steps, there are processing equipments that lower the efficiency of the installation space in the factory if aligned in the order of the processing steps due to characteristics of the processing equipments, such as the size of the processing equipment and the positions of the loader and unloader. Moreover, there are processing equipments whose installation positions are limited in the factory due to utilities (for example, gas related facilities such as a gas supplying equipment and an exhaust gas processing equipment). For example, in the case shown in Fig. 3, the photoelectric-conversion-layer depositing equipment (plasma CVD equipment) 10 must supply and receive exhaust gas from and to a gas related facility 200 provided outside the factory building. Since it is desirable to shorten the gas pipes as much as possible, in some cases, it is preferable to install the photoelectric-conversion-layer depositing equipment 10 as close to the wall of the factory building as possible. Since the height of the photoelectric-conversion-layer depositing equipment 10 from the floor is greater than the other processing equipments, it is preferable to use a ceiling crane when performing maintenance.
Therefore, it is difficult to make efficient use of space by, for example, constructing a room in the space above the equipment 10 (for example, on the second floor). In order to efficiently use space by constructing a large room on the second floor in a factory, the photoelectric-conversion-layer depositing equipment 10 must be installed as close to the wall of the factory building as possible, and lower processing equipments above which a second floor room can be constructed must be collected on the side opposite to the equipment 10. Therefore, the photoelectric-conversion-layer depositing equipment 10 is installed in an area P2 which is by the wall of the factory building, and the other processing equipments are installed in an area P1, which is opposite to the area P2. By constructing a room on a floor in the space above the area P1 (for example, a second floor) and installing the processing equipments used in the paneling step on this floor, the installation area in the factory can be reduced, and the floor area can be efficiently used.

In this way, instead of arranging the processing equipments in the order of the processing steps, by disposing the processing equipments in series in positions appropriate for installation in the thin-film solar cell factory and using the common substrate storage racks and the substrate moving devices installed in the periphery, the substrates can be efficiently conveyed to the required equipment used for the subsequent step. Using the common substrate storage racks ensures dual functions: automatic storage and flexibility of each equipment handling the substrates. The installation position in the factory may be, for example, sites for installing processing equipments having similar heights or sites designated based on the utilities to be used. In this embodiment, since the gaps between processing equipments are used as common maintenance spaces, the size of the maintenance space can be reduced.

Furthermore, when some of the thin-film solar cell manufacturing steps are changed in order or omitted, the order of the thin-film solar cell manufacturing steps can be changed by changing the control program of the substrate-processing control device 17, without moving or reinstalling the processing equipments corresponding to the changed steps. Thus, the factory has excellent production flexibility.

In this embodiment, each of the processing equipments has good installation flexibility compared to that in a snake-like line according to the related art, as shown in Fig. 1. In this way, a manufacturing line that is suitable for production and the available factory space can be formed by reducing the size of unused space, and thus, the installation space efficiency in the factory can be improved. For example, the installation space of processing equipments used in the paneling step of the thin-film solar-cell manufacturing system 30 shown in Fig. 3 takes up approximately 40% less space compared with those used in the paneling step of the thin-film solar-cell manufacturing system shown in Fig. 1.

Next, the common substrate storage racks 40 will be described in detail.

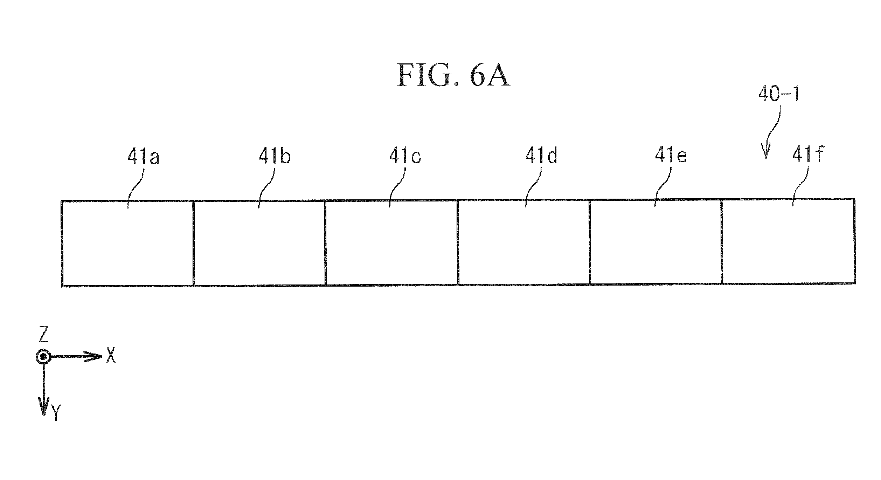

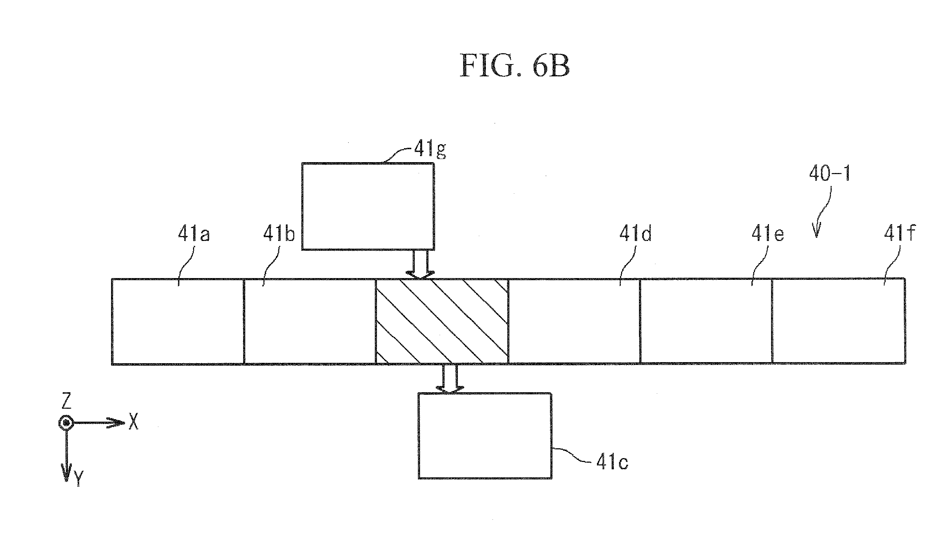

Figs. 6A and 6B are schematic views of the common substrate storage racks according to this embodiment. Here, the common substrate storage rack 40-1 will be described. However, the common substrate storage rack 40-2 has the same configuration. As shown in Fig. 6A, the common substrate storage rack 40-1 includes a plurality of substrate storage racks 41, which are aligned in the X direction. For example, if one of the substrate storage racks 41 can accommodate 50 substrates, a total of 300 substrates can be stored in 6 substrate storage racks 41a to 41f, as shown in the drawing.

As shown in Fig. 6B, for example, if the substrate storage rack 41c is filled with substrates and is unable to receive substrates from other processing equipments because one of the processing equipments has to be shut down for a long period of time and a large number of processed substrates accumulate upstream of this processing equipment, the processing equipment that is shut down for a long period of time affects the processing work of the processing equipments upstream and downstream. In such a case, the substrate storage rack 41c, which is filled with substrates, can be removed and moved to another storage area and an empty substrate storage rack 41g can be inserted in its place. In this way, if one of the substrate storage racks 41 is filled and is unable to accommodate the subsequent substrates, other substrate storage racks 41 can be used instead, and flexible operation, such as the processing equipments upstream and downstream of the shut-down processing equipment continuing their processing, becomes possible. As a moving method, conveying using a ceiling crane described in Japanese Unexamined Patent Application, Publication No. 2005-235904 may be employed.

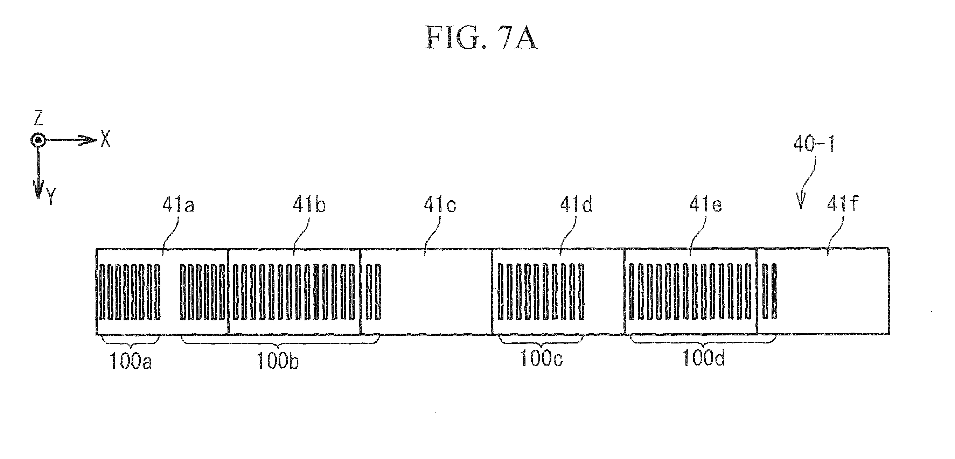

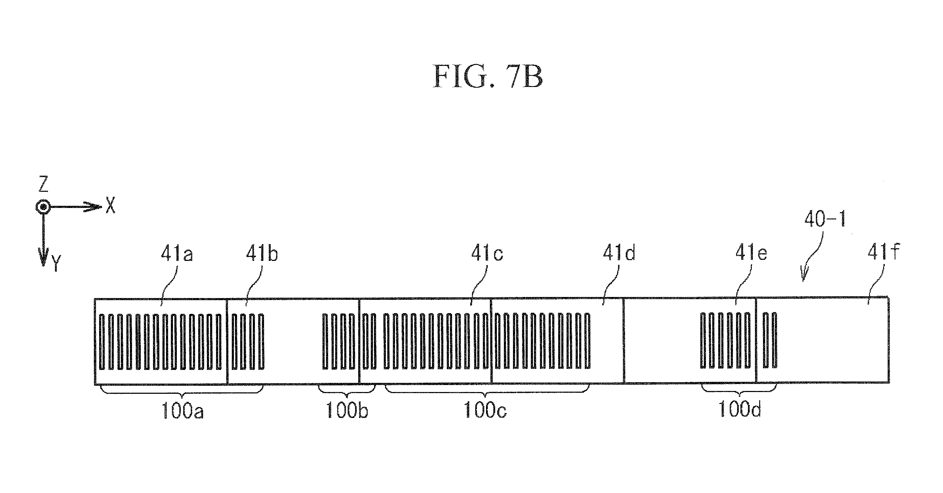

Figs. 7A and 7B are schematic views showing examples of the use of the common substrate storage racks according to this embodiment. Figs. 7A and 7B illustrate examples of accumulated substrates at different points of time. The number of substrates accumulated after a processing step differs depending on the processing condition of each processing step. At a certain point in time, as shown in Fig. 7A, substrates 100a which have completed processing step A, substrates 100b which have completed processing step B, substrates 100c which have completed processing step C, and substrates 100d which have completed processing step D are stored in the common substrate storage rack 40-1. One substrate storage rack 41 is sufficient for accommodating the substrates 100a and substrates 100c. However, to accommodate the substrates 100b and substrates 100d, two substrate storage racks 41 are required.
At a certain point in time, as shown in Fig. 7B, the substrates 100a which have completed the processing step A, the substrates 100b which have completed the processing step B, the substrates 100c which have completed the processing step C, and the substrates 100d which have completed the processing step D are stored in the common substrate storage rack 40-1. One substrate storage rack 41 is sufficient for accommodating the substrates 100b and substrates 100d. However, to accommodate the substrates 100a and substrates 100c, two substrate storage racks 41 are required.

When considering such a situation, in the case shown in Fig. 1 according to the related art, two substrate storage racks 41 must be provided for each of the processing steps A, B, C, and D. In other words, eight substrate storage racks 41 are required.
However, as shown in Figs. 7A and 7B, since each of the substrate storage racks 41 of the common substrate storage rack 40-1 is shared in each processing step, any of the nearby substrate storage racks 41 may be used in each processing step, regardless of the substrate storage racks 41 not being the closest. In other words, when the number of accumulated substrates increases, a plurality of substrate storage racks 41 other than the closest substrate storage rack 41 can be used. In such a case, the substrate storage rack 41 can be used regardless of it being used in other processing steps. In this way, the required number of substrate storage racks 41 is reduced and the amount of margin can be reduced. In this case, the required number of substrate storage racks 41 is six in total.

Since the processing speed and the maintenance cycle of each processing step do not match, substrate storage racks for temporarily storing accumulated substrates are required. If the substrates are conveyed without accumulation in one continuous line, the productivity of the entire factory is significantly reduced because there are differences in the processing speed and the maintenance cycle of each of the processing equipments. If substrate storage racks are provided for each processing step (related art in Fig. 1), substrate storage racks corresponding in number to the maximum number of substrates that accumulate in each processing step are required. Moreover, the processing line may become complicated because, if the accumulation of substrates temporarily increases, measures such as storing the substrates in a substrate cassette and moving the substrates outside the factory must be taken.

However, with the common substrate storage racks according to this embodiment, the substrate storage racks are not used for specific processing equipment but are shared by a plurality of processing equipments. In this way, the numbers of substrates stored in the substrate storage racks do not have to correspond to the maximum number required by each of the processing equipments, and thus the substrate storage racks can be efficiently used, and the size can be reduced. For example, the installation space, including the storage space, of processing equipments takes up approximately 50% less space compared with the storage space of the substrate cassettes installed in an S-shaped snake line, as shown in the related art in Fig. 1. By reducing the total number of substrate storage racks, the space in the factory can be efficiently used, and costs of the substrate storage racks can be reduced. Moreover, the accumulation of substrates in each processing step can be controlled, and the processing line can be prevented from becoming complicated. Moreover, if the number of substrates to be stored increases, the substrate storage rack can be lifted and temporarily removed from the processing step by, for example, a ceiling crane, and an empty substrate storage rack can be inserted to the space created by the removal.

In the above-described cases shown in Figs. 6A, 6B, 7A, and 7B, the common substrate storage racks 40-1 and 40-2 do not have areas designated for each processing equipment and can be shared by all of the processing equipments. However, a certain allocated area may be set in advance. For example, the substrate storage rack 41 closest to a processing equipment and the substrate storage racks 41 on both sides of this substrate storage rack 41 may be set as an allocated area. In such a case, the substrates associated with the processing equipments will be disposed at positions not too far away from the processing equipment, thus reducing the traveling distance of the substrates. However, even in such a case, since a designated area is not set, sharing of the areas is not restricted.

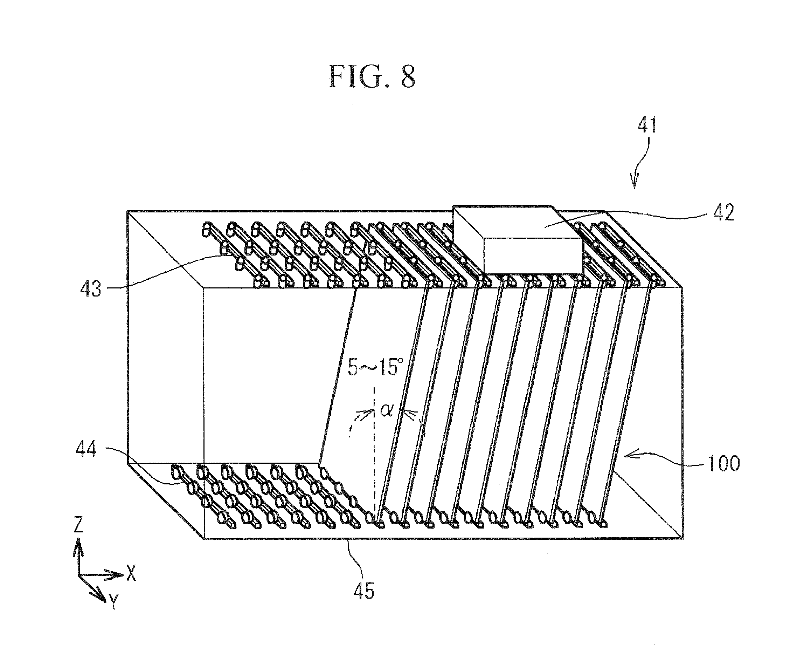

Next, the substrate storage racks 41 will be described in detail.
As described above, each of the common substrate storage racks 40 include a plurality of substrate storage racks 41, which are aligned in the X direction. Fig. 8 is a perspective view of the configuration of the substrate storage racks according to this embodiment. Each of the substrate storage racks 41 includes a case 45, a filter device 42, a plurality of upper-substrate supporting rollers 43, and a plurality of lower-substrate supporting rollers 44.
The case 45 is substantially cubic. One of the surfaces orthogonal to the Y direction is open to allow the substrates 100 to be loaded and unloaded. The substrates 100 include not only unprocessed substrates but also substrates that have been processed by film deposition, etching, and the like.
The filter device 42 sucks in outside air, filters the air with a HEPA filter, and supplies the filtered air, which has a higher cleanliness level than the ambient air, to the case 45 so that the inside of the case 45 becomes slightly positive pressure.
The plurality of upper-substrate supporting rollers 43 are aligned parallel to each other in the X direction on the inner upper surface of the case 45 such that their longitudinal directions are parallel to the Y direction. Each of the upper-substrate supporting rollers 43 includes a plurality of rollers which can rotate to smoothly move the substrates 100.
The plurality of lower-substrate supporting rollers 44 are aligned parallel to each other in the X direction on the inner lower surface of the case 45 such that their longitudinal directions are parallel to the Y direction. Each of the lower-substrate supporting rollers 44 includes a plurality of rollers which can rotate to smoothly move the substrates 100.

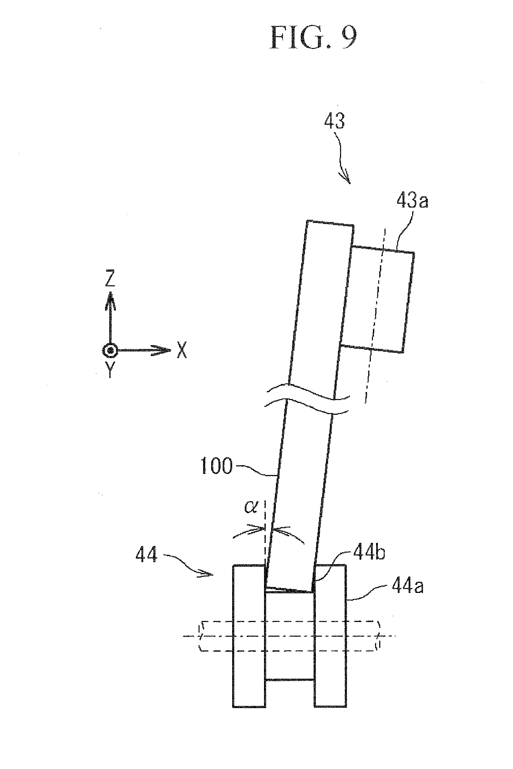

The processed surface, such as the film-deposition surface, of the substrate 100 on which, for example, film deposition has been performed is supported by the upper-substrate supporting rollers 43 and the lower-substrate supporting rollers 44 at an angle α to the vertical direction, and the orientation of the substrate 100 is stably maintained by the substrates own weight such that the film-deposition surface does not touch the rollers. Fig. 9 is a schematic view of a substrate being supported at a substrate storage rack. The lower section of the substrate 100 is supported by depressed sections 44b of rollers 44a of the lower-substrate supporting rollers 44. The upper surface (the surface opposite to the film-deposition surface) of the substrate 100 is supported by rollers 43a of the upper-substrate supporting rollers 43. When the substrate 100 is loaded or unloaded into or from the substrate storage rack 41, the rollers 43a and the rollers 44a rotate while supporting the substrate 100 so as to smoothly move the substrate 100. The substrate 100 is tilted in the direction of the surface opposite to the surface that contacts the rollers 43a when the surface on which the solar cell is to be formed (film-deposition surface) is the upper surface. The depth of the depression of the depressed section 44b is smaller than the width of the peripheral region 94 of the solar cell module. In this way, since the rollers 43a that support the weight of the substrate 100 will be positioned opposite to the film surface, and the depressed section 44b does not contact the film, the film-deposition surface will not be damaged when the substrate 100 is loaded into or unloaded from the substrate storage rack 41. For the rollers, such as the rollers 43a and the rollers 44a, it is preferable to use a material that does not damage the substrates and that generates less dust. For example, UPE, Duracon, or Teflon (registered trademark) may be used.

In order to maintain a stable conveying state due to the substrate's weight, it is preferable to set the angle α of the substrate 100 relative to the vertical direction at an angle of 7° or larger and preferable 12° or smaller from the device space, as described in "Carrying Device and Vacuum Processing System" in Japanese Unexamined Patent Application, Publication No. 2000-177842. However, the substrate storage racks 41 support the substrates 100 in a motionless state. Therefore, the allowed range can be increased slightly, and, according to verification test results, the substrate 100 can be stably held by its own weight if it is tilted at an angle of 5° or larger. On the other hand, since many substrates are stocked, only the size of the unused space caused by the tilted substrate at the ends of the substrate storage rack 41 changes when the tilt angle relative to the vertical direction changes slightly. Therefore, the increase in size of the rack is very small. Therefore, the allowed range can be increased slightly in the direction of increasing angle, and the size can be kept sufficiently small with respect to the space occupied if the angle is 15° or smaller.

Since the bending of the substrate 100 is equivalent to the sine component of the tilt angle in the vertical direction, within the above-described tilt angle range, the bending is reduced to approximately 1/10 of that when the substrate is horizontal. In this way, the distance between substrates loaded in the common substrate storage racks 40 can be reduced to approximately 30 mm from approximately 50 mm, which is the distance when the substrates are horizontal. As a result, the installation space of the substrate storage racks 41 can be reduced by approximately 20%.

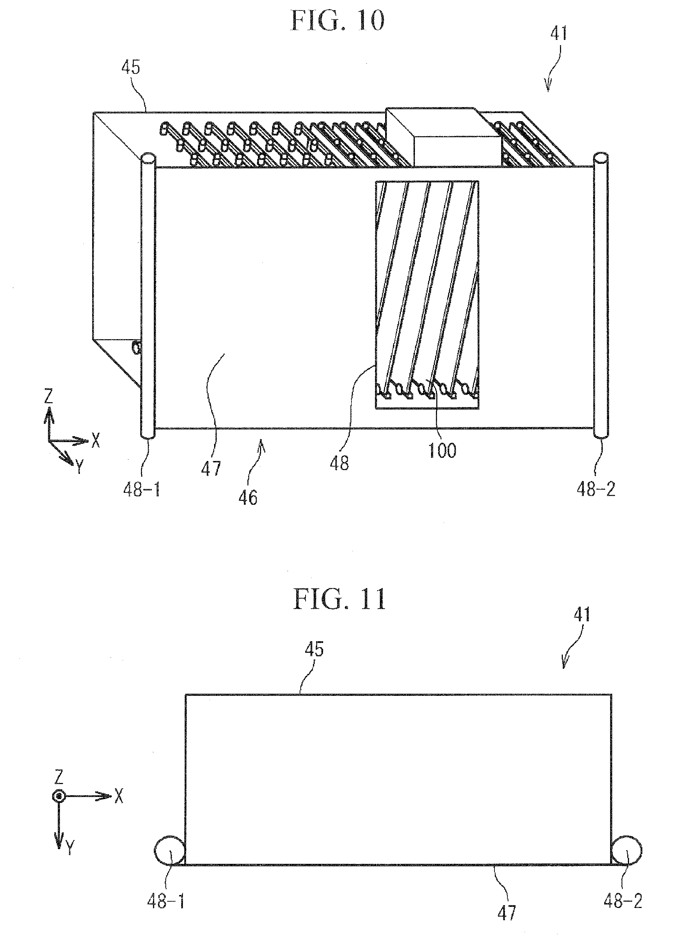

Fig. 10 is a perspective view of an opening mechanism of the substrate storage rack according to this embodiment. Fig. 11 is a top view of the opening mechanism of the substrate storage rack according to this embodiment. An opening mechanism 46 restricts the area of the opening for loading and unloading the substrates 100, which is formed in the surface of the case 45 orthogonal to the Y direction. The opening mechanism 46 includes sheet storage sections 48-1 and 48-2 and a sheet 47. The cleanliness level of the inside of the substrate storage rack can be easily improved by restricting the size of the opening.

One of the sheet storage sections 48-1 and 48-2 takes up the sheet 47, and the other lets out the sheet 47. The sheet 47 has substantially the same width as the surface of the case 45 orthogonal to the Y direction so as to cover this surface. However, an open section 49 is formed in part of the sheet 47. When the open section 49 appears between the sheet storage sections 48-1 and 48-2 (on the surface of the case 45 orthogonal to the Y direction), the substrates 100 can be loaded or unloaded through the open section 49. An antistatic vinyl curtain for a clean booth may be used as the sheet 47. The opening mechanism 46 and the case 45 constitute a clean bench that is capable of maintaining a high cleanliness level for the substrates 100.
Here, an example in which the substrates 100 are loaded or unloaded through one of the two surfaces of the case 45 orthogonal to the Y direction will be described. If the substrates 100 are to be loaded or unloaded through both surfaces of the case 45 orthogonal to the Y direction (when both surfaces of the case 45 orthogonal to the Y direction are open), an opening mechanism 46 may also be provided on the other surface.

Next, the substrate moving device will be described in detail.

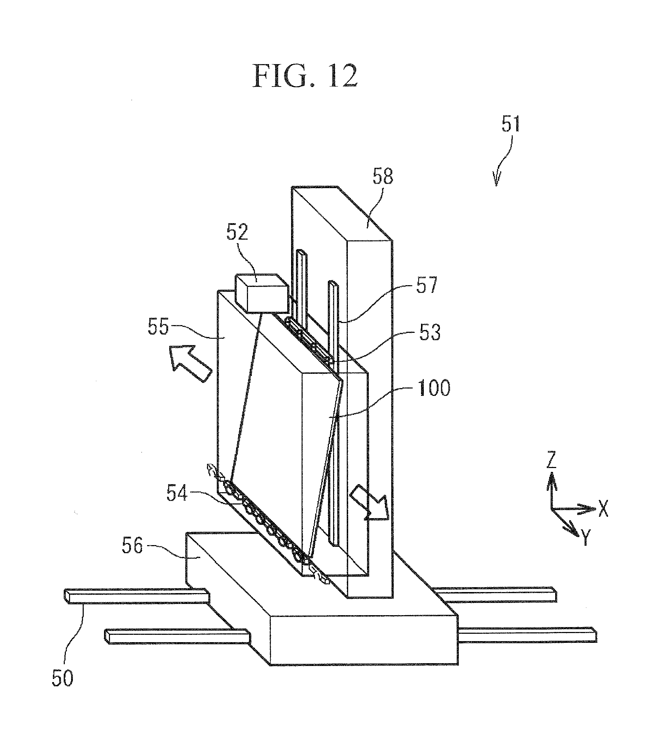

Fig. 12 is a perspective view of the configuration of a substrate moving device according to this embodiment. A substrate moving device 51 is a device for moving a substrate positioned between each processing equipment and the common substrate storage rack 40 or another device and for performing loading and unloading. The substrate moving device 51 is provided at each of the regions 20-1 and 20-2 and moves along a moving rail 50 extending in the X direction. The substrate moving device 51 includes a filter device 52, upper-substrate supporting rollers 53, lower-substrate supporting rollers 54, a clean bench 55, a mover moving device 56, a mover-section vertical-moving device 57, and a mover-section supporting base 58.

The filter device 52 sucks in outside air, filters the air with a HEPA filter, and supplies the filtered air, which has a higher cleanliness level than the ambient air, to the clean bench 55 so that the inside of the clean bench 55 becomes slightly positive pressure.
The upper-substrate supporting rollers 53 are aligned on the inner upper surface of the clean bench 55 such that their longitudinal directions are parallel to the Y direction. Each of the upper-substrate supporting rollers 53 includes a plurality of rollers, which support the surface of the substrate 100 opposite to the upper film-deposition surface and which can rotate to smoothly move the substrates 100.
The lower-substrate supporting rollers 54 are aligned on the inner lower surface of the clean bench 55 such that their longitudinal directions are parallel to the Y direction. Each of the lower-substrate supporting rollers 54 includes a plurality of rollers, which are rotated when the substrates 100 are moved in the moving direction. The end sections of the lower-substrate supporting rollers 54 on the side of the common substrate storage racks 40 move toward the common substrate storage racks 40 when the substrates are loaded or unloaded. Similarly, the end sections of the lower-substrate supporting rollers 54 on the side of the processing equipment move toward the processing equipment when the substrates are loaded or unloaded.
The clean bench 55 is substantially cubic. The surface orthogonal to the Y direction has a door (not shown), which is opened when the substrates are loaded or unloaded. The surface orthogonal to the Y direction also has a slit-like opening, which does not hinder the loading and unloading of the substrates. The clean bench 55 and the filter device 52 allow the substrate moving device to hold the substrate 100 in a space with a cleanliness level that is stable even while the substrates are being moved.
The mover-section moving device 56 supports the mover-section supporting base 58, which supports a mover-section and the mover-section vertical-moving device 57. However, the mover section includes the filter device 52, the upper-substrate supporting rollers 53, the lower-substrate supporting rollers 54, and the clean bench 55. The mover-section moving device 56 moves along the moving rail 50 in the ±X directions to move the mover-section supporting base 58 to a desired position in the ±X directions.
The mover-section vertical-moving device 57 moves the mover section in the vertical direction (Z direction) such that the substrate conveying level of the mover section in the Y direction matches the processing equipment and the common substrate storage rack 40 when the substrate is loaded or unloaded.
The mover-section supporting base 58 moves the mover-section vertical-moving device 57 in the vertical direction (Z direction).

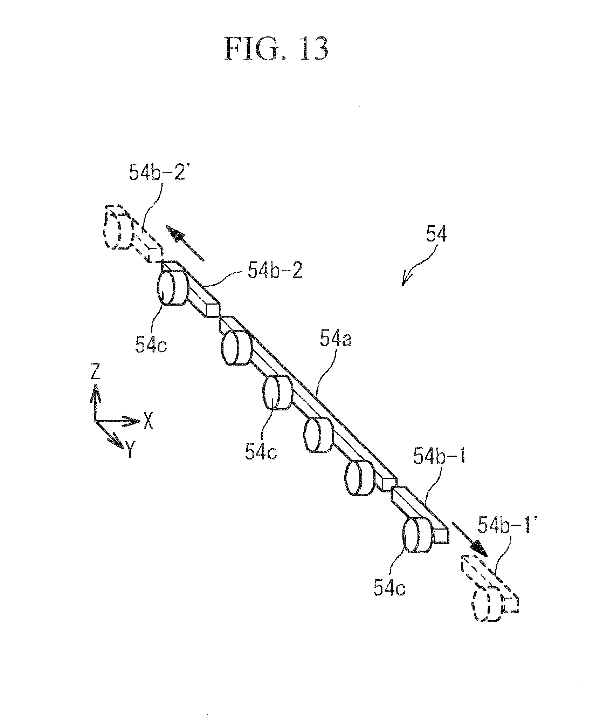

Fig. 13 is a perspective view illustrating the operation of the lower-substrate supporting rollers 54 according to this embodiment. The lower-substrate supporting rollers 54 have a member 54a that extends in the Y direction, members 54b (54b-1 and 54b-2) that extend in the Y direction and that are provided at both ends of the member 54a, and a plurality of rollers 54c. When the substrate 100 is moved, the plurality of rollers 54c are rotated in the moving direction of the substrate 100.

When the substrate is unloaded, an extension mechanism (not shown) moves the member 54b-1, which is provided at the end of the member 54a closer to the common substrate storage rack 40, toward the common substrate storage rack 40 (to the position 54b-1') and to a position proximal to the lower-substrate supporting rollers 44 of the common substrate storage rack 40. In this way, the substrate can be stably moved from the substrate moving device 51 to the common substrate storage rack 40. When the substrate is loaded, the extension mechanism moves the member 54b-1 temporarily downward (-Z direction), toward the common substrate storage rack 40 (in the direction 54b-1'), and then upward (+Z direction) to the position 54b-1'. When the member 54b-1 (position 54b-1') moves upward, it grabs the edge of the substrate 100 in the common substrate storage rack 40. Then, when the member 54b-1 returns to its original position, the substrate 100 is pulled out toward the substrate moving device 51. Then, by driving the rollers 54c, the substrate 100 can be stably moved to the substrate moving device 51.

Similarly, when the substrate is unloaded, an extension mechanism (not shown) moves the member 54b-2, which is provided at the end of the member 54a closer to the common substrate storage rack 40, toward the processing equipment (to the position 54b-2') and to a position proximal to a substrate loading section (not shown) of the processing equipment. In this way, the substrate can be stably moved from the substrate moving device 51 to the processing equipment. When the substrate is loaded, the extension mechanism moves the member 54b-2 temporarily downward (-Z direction), toward the common processing equipment (in the direction 54b-2'), and then upward (+Z direction) to the position 54b-2'. When the member 54b-2 (position 54b-2') moves upward, it grabs the edge of the substrate 100 in the processing equipment. Then, when the member 54b-2 returns to its original position, the substrate 100 is pulled out toward the substrate moving device 51. Then, by driving the rollers 54c, the substrate 100 can be stably moved to the substrate moving device 51.

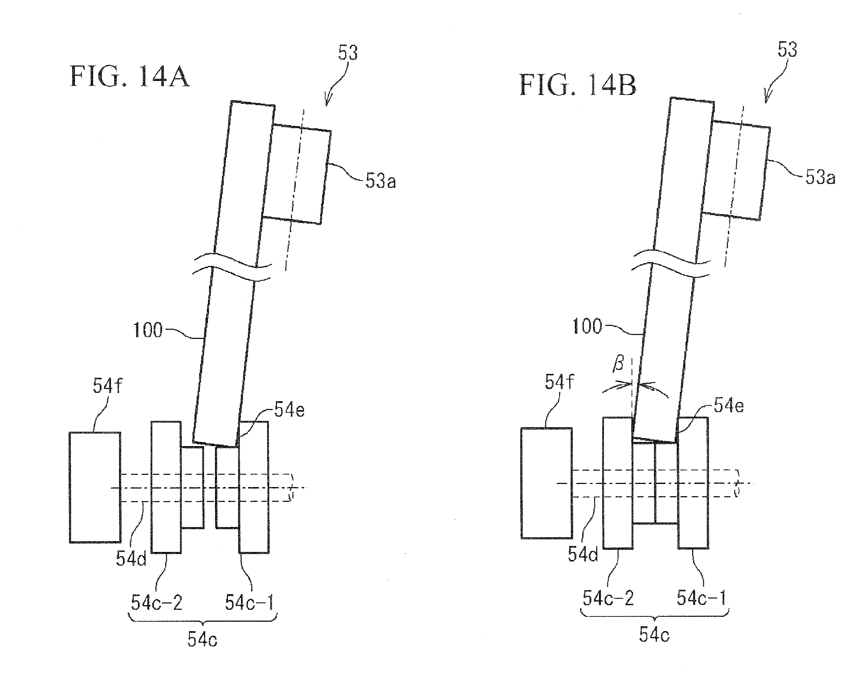

The substrate 100 is supported by the upper-substrate supporting rollers 53 and the lower-substrate supporting rollers 54 at an angle β to the vertical direction in such a manner that the processed surface, such as the film-deposition surface, is the upper surface. Fig. 14A is a schematic view of the substrate being supported in the substrate moving device. Fig. 14B is a schematic view of the substrate being moved in the substrate moving device. The lower side of the substrate 100 is supported by a depressed section 54e of the rollers 54c of the lower-substrate supporting rollers 54. Furthermore, the surface opposite to the film-deposition surface of the substrate 100 is supported by rollers 53a of the upper-substrate supporting rollers 53 disposed above the substrate 100. The rollers 54c each include roller members 54c-1 and 54c-2.

When the substrate moving device 51 is holding the substrate 100, as shown in Fig. 14A, the rollers 53a support the substrate 100 in a similar manner as the rollers 43a. At the same time, although the rollers 54c support the substrate 100 with the roller members 54c-1 and the roller members 54c-2, the roller members 54c-1 and the roller members 54c-2 loosen to increase the width of the depressed section 54e and do not grab the substrate 100.
It is preferable that a brake be provided on the rollers 53a so that the position of the substrates does not change while the substrate moving device 51 moves. It is preferable to employ a method in which a braking mechanism is provided on the rotary shaft of the roller by grabbing the substrate with the rollers 53a.

When the substrate moving device 51 loads or unloads the substrate 100, the rollers 53a support the substrate 100 in the state shown in Fig. 14A and rotate to facilitate the movement of the substrate 100. At the same time, the roller members 54c-1 and the roller members 54c-2 loosen to increase the width of the depressed section 54e and are rotated by a roller driving section 54f in order to move the substrate 100 in a desired direction. However, as described above, when the members 54b-1 and 54b-2 extend to the common substrate storage rack 40 or the processing equipment to grab and pull out the substrate 100, the rollers 54c are in the state shown in Fig. 14B. In other words, the roller members 54c-2 coupled with a shaft member 54d are pushed against the roller members 54c-1 due to the movement of the shaft member 54d driven by the roller driving section 54f, and the width of the depressed section 54e is decreased. As a result, the rollers 54c can grab the substrate 100.

The substrate 100 is tilted in the direction of the surface opposite to the surface that contacts the rollers 53a when the surface on which the solar cell is to be formed (film-deposition surface) is the upper surface. The depth of the depression of the depressed section 54e is smaller than the width of the peripheral region 94. In this way, since the rollers 53a that support the weight of the substrate 100 will be positioned opposite to the film surface, and the depressed section 54e does not contact the film, the film-deposition surface will not be damaged when the substrate 100 is loaded into or unloaded from the substrate moving device 51.

In order to maintain a stable conveying state due to the substrate's weight, it is preferable to set the angle β of the substrate 100 relative to the vertical direction at an angle of 7° or larger and preferably 12° or smaller from the device space, as described in "Carrying Device and Vacuum Processing System" in Japanese Unexamined Patent Application, Publication No. 2000-177842.

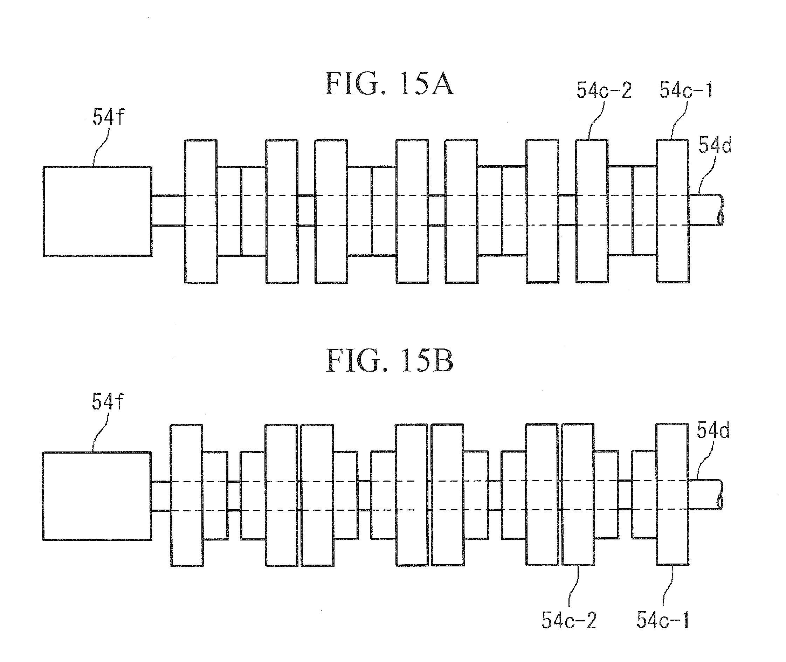

Figs. 12 to 14B describe a substrate moving device that conveys only one substrate. However, the present invention is not limited thereto, and a plurality of substrates may be simultaneously moved by increasing the number of the upper-substrate supporting rollers 53 and the lower-substrate supporting rollers 54. Fig. 15A is a schematic view illustrating the state of the lower-substrate supporting rollers when substrates are being supported or moved. Here, lower-substrate supporting rollers that grab four substrates simultaneously are described. Fig. 15B is a schematic view illustrating the state of the lower-substrate supporting rollers when substrates are being grabbed. The configuration and the operation are the same as those illustrated in Figs. 12 to 14B, except that the numbers of the upper-substrate supporting rollers 53 and the lower-substrate supporting rollers 54 are increased, and thus, descriptions thereof will be omitted.

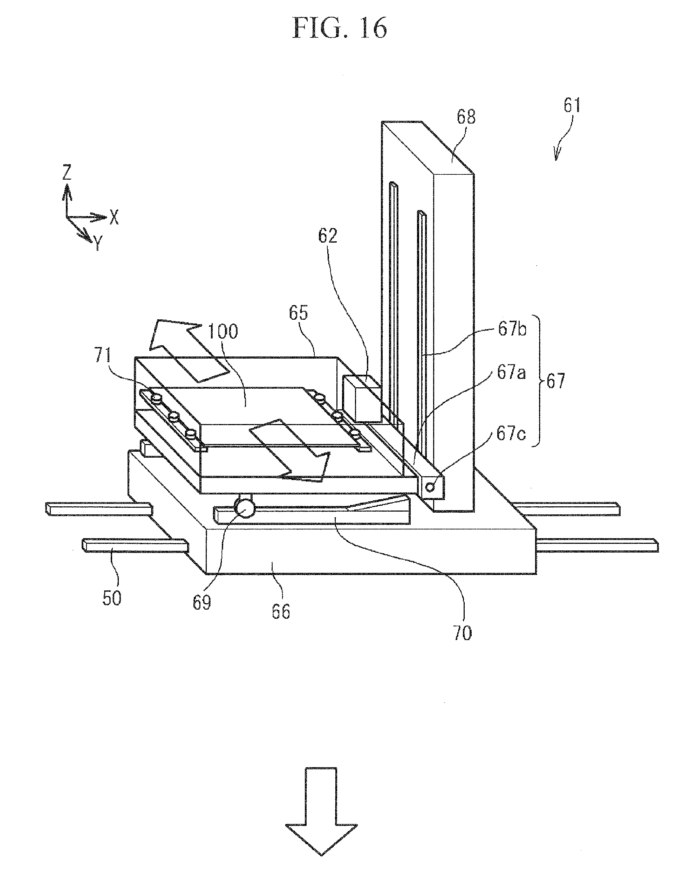

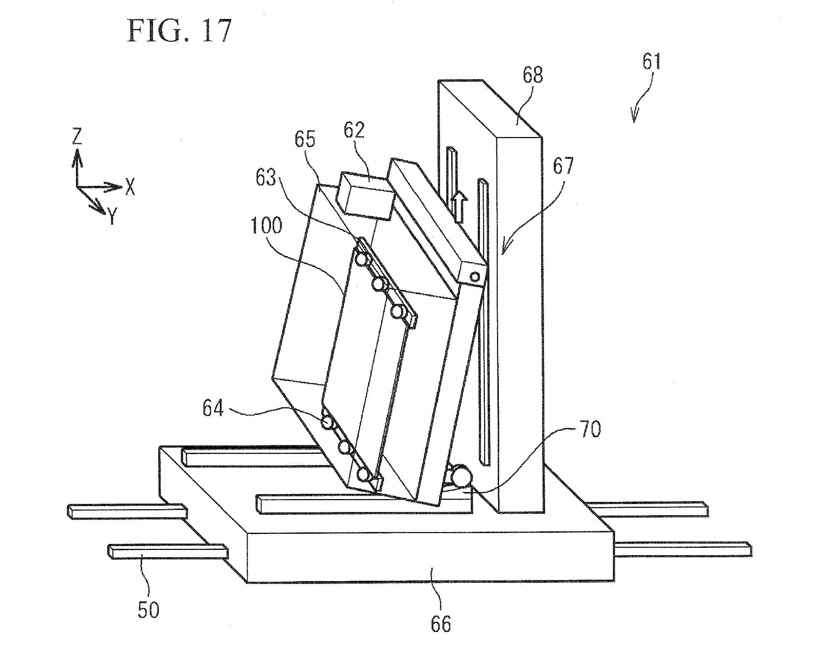

Figs. 12 to 15B illustrate the substrate moving device that supports, moves, loads, and unloads substrates while the substrates are substantially upright (vertical direction). However, the present invention is not limited thereto, and the substrates may be supported, moved, loaded, and unloaded while the substrates are placed laterally (horizontal direction). This is because some processing equipments process substrates in a horizontal orientation, and for such processing equipments, in some cases it is inefficient to provide a substrate-tilt-angle rotating mechanism for the loaders and unloaders of the processing equipments. Figs. 16 and 17 are perspective views illustrating another configuration of the substrate moving device according to this embodiment. Fig. 16 illustrates the substrate placed laterally, and Fig. 17 illustrates the substrate substantially upright (corresponding to the cases shown in Figs. 12 to 15B). A substrate moving device 61 is a device for moving a substrate positioned between each processing equipment and the common substrate storage rack 40 or another device and for performing loading and unloading. The substrate moving device 61 is provided at each of the regions 20-1 and 20-2 and moves along a moving rail 50 extending in the X direction. The substrate moving device 61 includes a filter device 62, substrate-side supporting rollers 63, substrate-side supporting rollers 64, a clean bench 65, a mover moving device 66, a mover-section vertical-moving device 67, and a mover-section supporting base 68, moving-section rollers 69, and a moving rail 70.

The filter device 62 sucks in outside air, filters the air with a HEPA filter, and supplies the filtered air, which has a higher cleanliness level than the ambient air, to the clean bench 65 so that the inside of the clean bench 65 becomes slightly positive pressure.
The substrate-side supporting rollers 63 and the substrate-side supporting rollers 64 have functions of supporting the horizontal load of the substrates and guiding the substrates in the transverse direction.
The clean bench 65 is substantially cubic. The surface orthogonal to the Y direction has a door (not shown), which is opened when the substrates are loaded or unloaded. The surface orthogonal to the Y direction also may have a slit-like opening, which does not hinder the loading and unloading of the substrates. The clean bench 65 and the filter device 62 allow the substrate moving device to hold the substrate 100 in a space with a cleanliness level that is stable even while the substrates are being moved.

In the state shown in Fig. 16, the substrate-side supporting rollers 63 and 64 are disposed parallel to the Y direction in the clean bench 65, and a plurality of rollers are provided. The plurality of rollers are rotated by a rotation driving unit (not shown) when the substrates 100 are moved in the moving direction.
During loading or unloading of a substrate horizontally (see the arrows), the substrate-side supporting rollers 63 and the substrate-side supporting rollers 64 can pull in the substrate 100 from both sides in the Y direction. Then, the substrate-side supporting rollers 63 and the substrate-side supporting rollers 64 are rotated, and the substrate 100 is unloaded outside the clean bench 65.
The mover moving device 66 holds a mover section, the mover-section vertical-moving device 67, the mover-section supporting base 68, and the moving rail 70. The mover section includes the filter device 62, the substrate-side supporting rollers 63, the substrate-side supporting rollers 64, and the clean bench 65, and a moving-section roller 69. The mover moving device 66 moves along the moving rail 50 in the ±X directions to move the mover section, the mover-section vertical-moving device 67, the mover-section supporting base 68, and the moving rail 70 to a desired position in the ±X directions.

When the substrate is loaded or unloaded, the mover-section vertical-moving device 67 moves the moving section so that the substrate in the moving section moves in substantially the longitudinal direction (substantially the vertical direction) or the lateral direction (horizontal direction) to correspond to the tilt with respect to the vertical direction of the device to or from which the substrate is loaded or unloaded. When the substrate is positioned in substantially the longitudinal direction (substantially the vertical direction) in the moving section, a mover-section vertical-moving device 67a is moved upward (+Z direction) along a moving guide 67b. In this way, while the moving-section rollers 69 move in the ±X direction on the moving rail 70, the main body of the moving section rotates relatively around a rotation supporting shaft 67c. As a result, the state illustrated in Fig. 17 occurs. The moving section is moved such that it becomes substantially the longitudinal direction (substantially the vertical direction) or the lateral direction (horizontal direction). When the substrate in the moving section is lateral (horizontal), the operation is substantially opposite to that when the substrate is longitudinal.
The mover-section supporting base 68 holds the mover-section vertical-moving device 67 in the vertical direction (Z direction).
The moving-section rollers 69 are provided in the clean bench 65 at a position corresponding to the position of the moving rail 70. When the moving section is moved, the moving section can be smoothly moved by moving it on the moving rail 70.
The moving rail 70 is provided on the mover moving device 66 and guides the moving-section rollers 69.

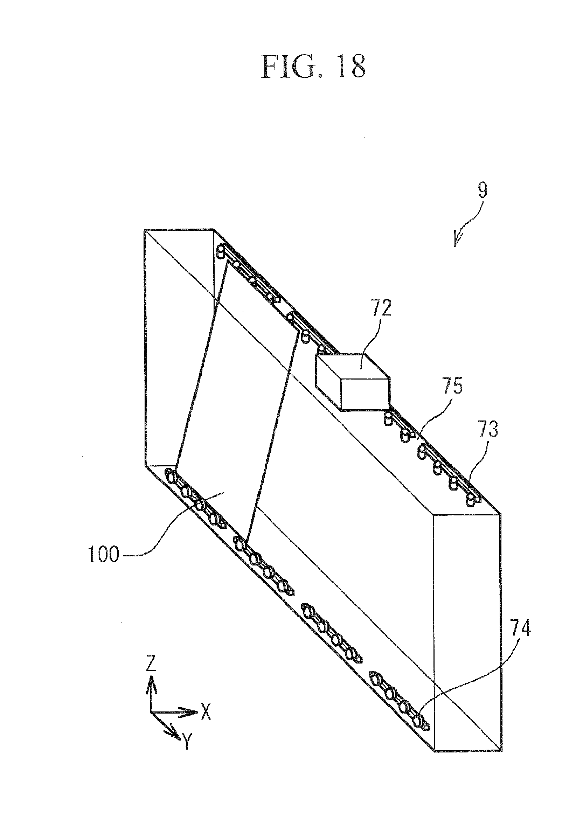

When a substrate is to be moved from one of the common substrate storage racks 40-1 and 40-2 to the other, the substrate conveyer 9 can be used. Fig. 18 is perspective view of the configuration of the substrate conveyer according this embodiment. The substrate conveyer 9 includes a filter device 72, upper-substrate supporting rollers 73, lower-substrate supporting rollers 74, and a clean bench 75. The filter device 72, the upper-substrate supporting rollers 73, the lower-substrate supporting rollers 74, and the clean bench 75 are basically the same as the filter device 52, the upper-substrate supporting rollers 53, the lower-substrate supporting rollers 54, and the clean bench 55, respectively. However, unlike the upper-substrate supporting rollers 53 and the lower-substrate supporting rollers 54, intermediate sections of the upper-substrate supporting rollers 73 and the lower-substrate supporting rollers 74 are extended because the moving distance of the substrate is long. The clean bench 75 and the filter device 72 allow the substrate moving device to hold the substrate 100 in a space with a cleanliness level that is stable even while the substrates are being moved. By using the substrate conveyer 9, for example, not only the processing equipments share the substrate storage space in only one of the common substrate storage racks 40 (for example, 40-1), but they can also substantially share the substrate storage space in the other common substrate storage racks 40 (for example, 40-2). In other words, the flexibility of the storage space for the substrate 100 is increased. A plurality of substrate conveyers 9 may be provided. By providing a plurality of substrate conveyers 9, when necessary, the takt time for moving the substrates can be shortened, and the flexibility of the production line can be increased.

In this embodiment, since the common substrate storage racks and the substrate moving device use clean benches, substrates can be stored and moved in clean spaces. For example, when the entire thin-film solar-cell manufacturing system 30 is in a normal atmosphere (for example, about class 500,000), the substrate storage rack is about class 1,000 to 5,000 with an opening mechanism or about class 10,000 to 50,000 without an opening mechanism. The substrate moving device is about class 10,000. Moreover, when the regions 20, including the space between the common substrate storage rack and the substrate moving device and the space between the substrate moving device and the processing equipment, are covered with clean benches or clean booths (not shown), if the cleanliness level of the regions is about class 100,000, the substrate storage rack is about class 1,000 with an opening mechanism or about class 1,000 to 5,000 without an opening mechanism. The substrate moving device is about class 1,000. In this way, strict management, such as constructing the entire factory as a clean room, is not required, and the cost of the factory can be reduced. Moreover, since each device in the factory is in a normal atmosphere, special work management involving wearing lint-free clothes is not required. In particular, the operability during maintenance can be improved, thus improving productivity.

As described above, the thin-film solar-cell manufacturing system according to the present invention enables the installation space in the factory to be reduced. The common substrate storage racks according to the present invention enables the space required for storage and the installation space to be reduced. The common substrate storage racks according to the present invention functions as a buffer for substrate accumulation and enables flexible operation corresponding to changes in the accumulation that occurs during the manufacturing steps.

The present invention is not limited to the above-described embodiments, and the embodiments may be modified within the scope of the present invention.

## Claims

1. A thin-film solar-cell manufacturing system comprising:
a first common substrate storage rack for accommodating a substrate tilted from the vertical direction; and
a plurality of processing equipments that process the substrate in manufacturing steps of a thin-film solar cell and that are arranged to unload the processed substrate to the first common substrate storage rack,
wherein the first common substrate storage rack is shared by the plurality of processing equipments and accommodates the substrate regardless of the processing order of the manufacturing steps.

2. The thin-film solar-cell manufacturing system according to Claim 1, further comprising:
a second common substrate storage rack for accommodating the substrate tilted from the vertical direction; and
a substrate-processing control device for controlling the processing order of the substrate,
wherein the plurality of processing equipments are arranged in a region between the first common substrate storage rack and the second common substrate storage rack, the plurality of processing equipments being arranged such that one of a substrate unloader or a substrate loader faces the first common substrate storage rack and the other faces the second common substrate storage rack,
wherein the first common substrate storage rack and the second common substrate storage rack are shared by the plurality of processing equipments, and
wherein the substrate-processing control device controls loading and unloading of the substrate to and from at least some of the plurality of processing equipments and controls the loading and unloading of the substrate to and from the first common substrate storage rack and the second common substrate storage rack.

3. The thin-film solar-cell manufacturing system according to Claim 2,
wherein at least some of the plurality of processing equipments are arranged in series with each other via the first common substrate storage rack or the second common substrate storage rack, and the arrangement order of at least some of the plurality of processing equipments does not follow the manufacturing steps of the thin-film solar cell.

4. The thin-film solar-cell manufacturing system according to Claim 3,
wherein the order of the manufacturing steps of the thin-film solar cells of at least some of the plurality of processing equipments can be changed by the substrate-processing control device, without changing the arrangement order of the plurality of processing equipments.

5. The thin-film solar-cell manufacturing system according to Claim 3 or 4,
wherein each of the plurality of processing equipments is arranged at a region assigned on the basis of the height of each of the plurality of processing equipments.

6. The thin-film solar-cell manufacturing system according to Claim 3 or 4,
wherein each of the plurality of processing equipments is arranged in a region assigned on the basis of the utility to be used by each of the plurality of processing equipments.

7. The thin-film solar-cell manufacturing system according to one of Claims 1 to 6,
wherein the first common substrate storage rack includes a first cleaning device for maintaining the cleanliness level of an inner atmosphere at a cleanliness level higher than an outside atmosphere, and
wherein the second common substrate storage rack includes a second cleaning device for maintaining the cleanliness level of the inner atmosphere at a cleanliness level higher than the outside atmosphere.

8. The thin-film solar-cell manufacturing system according to Claim 7, further comprising:
a first chamber including a space between the first common substrate storage rack and the plurality of processing equipments;
a third cleaning device for maintaining the cleanliness level of an atmosphere inside the first chamber at a cleanliness level higher than an atmosphere in other regions;
a second chamber including a space between the second common substrate storage rack and the plurality of processing equipments; and
a fourth cleaning device for maintaining the cleanliness level of an atmosphere inside the second chamber at a cleanliness level higher than an atmosphere in other regions.

9. The thin-film solar-cell manufacturing system according to Claim 8, further comprising:
a first substrate moving device for moving the substrate inside the first chamber; and
a second substrate moving device for moving the substrate inside the second chamber,
wherein the first substrate moving device includes a fifth cleaning device for maintaining the cleanliness level of an inside atmosphere at a cleanliness level higher than the outside atmosphere, and
wherein the second substrate moving device includes a sixth cleaning device for maintaining the cleanliness level of the inside atmosphere at a cleanliness level higher than an atmosphere in outside regions.

10. The thin-film solar-cell manufacturing system according to one of Claims 1 to 9,
wherein the tilt of the substrate being accommodated is between 5° or larger and 15° or smaller from the vertical direction.

11. The thin-film solar-cell manufacturing system according to one of Claims 1 to 10,
wherein the first common substrate storage rack and the second common substrate storage rack each include a plurality of substrate storage racks, and
wherein each of the plurality of substrate storage racks is replaceable by other substrate storage rack that is of the same configuration as each of the plurality of substrate storage racks.

12. The thin-film solar-cell manufacturing system according to one of Claims 1 to 11, further comprising:
a substrate conveyer that is provided between the first common substrate storage rack and the second common substrate storage rack, the substrate conveyer maintaining the cleanliness level of an inside atmosphere at a cleanliness level higher than an atmosphere in outside regions and moving the substrate from one of the first common substrate storage rack and the second common substrate storage rack to the other.

13. A common substrate storage rack comprising:
a plurality of substrate storage racks for accommodating a substrate tilted from the vertical direction, the storage racks being provided in series in a direction different from the loading and unloading direction of the substrate; and
a plurality of cleaning devices provided for the corresponding substrate storage racks, each cleaning device supplying gas of a cleanliness level higher than the cleanliness level of ambient atmosphere to the corresponding substrate storage rack,
wherein one of a substrate loader and a substrate unloader of a plurality of processing equipments that are used in manufacturing steps of a thin-film solar cell faces the plurality of substrate storage racks and are arranged such as to be shared by the plurality of processing equipments, and
wherein each of the plurality of substrate storage racks is replaceable by other substrate storage rack that is of the same configuration as each of the plurality of substrate storage racks.

14. A method of manufacturing a thin-film solar cell using a thin-film solar-cell manufacturing system, the thin-film solar-cell manufacturing system comprising:
a first common substrate storage rack accommodating a substrate at an angle between 5° or larger and 15° or smaller from the vertical direction,
a second common substrate storage rack accommodating the substrate at an angle between 5° or larger and 15° or smaller from the vertical direction,
a plurality of processing equipments that process the substrate in manufacturing steps of a thin-film solar-cell and that are arranged in a region between the first common substrate storage rack and the second common substrate storage rack such that one of a substrate loader and a substrate unloader faces the first common substrate storage rack and the other faces the second common substrate storage rack, and
a substrate-processing control device for controlling the processing order of the substrate,
wherein the first common substrate storage rack and the second common substrate storage rack are shared by the plurality of processing equipments,
wherein loading and unloading of the substrate to and from at least some of the plurality of processing equipments are controlled and the loading and unloading of the substrate to and from the first common substrate storage rack and the second common substrate storage rack are controlled by the substrate-processing control device, and
wherein the substrate is accommodated regardless of the processing order of the manufacturing steps,
the method of manufacturing a thin-film solar cell comprising the steps of:
(a) unloading a substrate accommodated in the first common substrate storage rack or the second common substrate storage rack and loading the substrate to one of the corresponding processing equipments among the plurality of processing equipments;
(b) processing the loaded substrate with the corresponding processing equipment; and
(c) unloading the processed substrate from the corresponding processing equipment and loading and accommodating the substrate to the first common substrate storage rack or the second common substrate storage rack.
